# EUROPEAN PATENT APPLICATION

(11) **EP 4 482 277 A1**
(43) Date of publication of application: **25.12.2024**
(21) Application number: 23845384.9
(22) Date of filing: 18.07.2023
(51) Int. Cl.: H10K 59/00

(54) **DISPLAY SUBSTRATE AND DISPLAY DEVICE**

(30) Priority: 28.07.2022 CN 202210898307
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: WANG, Mengqi, Beijing 100176 (CN); YU, Ziyang, Beijing 100176 (CN); JIANG, Zhiliang, Beijing 100176 (CN); HU, Ming, Beijing 100176 (CN); CHEN, Fei, Beijing 100176 (CN)
(74) Representative: Brötz, Helmut
(86) International application number: PCT/CN2023/107944
(87) International publication number: WO 2024/022172

(57) **Abstract**

A display substrate and a display device. In the display substrate, a display area has a lower edge extending along the transverse direction and a left edge extending along the longitudinal direction, the display area comprises a left display area and a right display area, the left display area comprises a first edge display area extending along the left edge and a first middle display area, and the transverse direction intersects with the longitudinal direction; a frame area surrounds at least part of the display area; a first power supply voltage lead provides a first power supply voltage and is located in the frame area; the first power supply voltage lead comprises a lower lead extending along a part of the lower edge corresponding to the first edge display area, but does not extend along a part of the lower edge corresponding to the first middle display area; a first power supply voltage line comprises an edge voltage line located in the first edge display area and a middle voltage line located in the first middle display area; and the edge voltage line is directly connected to the lower lead to provide the first power supply voltage for sub-pixels located in the first edge display area, and the middle voltage line is spaced apart from the lower lead.

## Description

The present application claims the priority to Chinese patent application No. 202210898307.2, filed on July 28, 2022, the entire disclosure of which is incorporated herein by reference in its entirety as a part of the present application.

### TECHNICAL FIELD

At least one embodiment of the present disclosure relates to a display substrate and a display device.

### BACKGROUND

Compared with the traditional liquid crystal display (LCD), organic light-emitting diode (OLED) display products have the advantages of self-illumination, wide color gamut, high contrast, lightweight and thinness, etc., making them widely used in the fields such as mobile phones, tablet computers, etc.

Generally, various signal lines, such as data lines, in the display region need to be led out to a fan-out region, and then connected to an integrated circuit (IC) through the fan-out region. The fan-out region is located in a frame region in which the display function is not performed. With the continuous pursuit of visual effects of display products, narrow frame and full-screen display have gradually become the main trend in the development of OLED display products.

### SUMMARY

At least one embodiment of the present disclosure provides a display substrate, and the display substrate includes: a display region, a non-display region, a first power voltage lead and a first power voltage line. The display region is provided with sub-pixels, and has a lower edge extending in a transverse direction and a left edge extending in a longitudinal direction, the transverse direction intersects with the longitudinal direction, a division line extending in the longitudinal direction divides the display region into a left display region and a right display region, and the left display region includes a first edge display region extending along the left edge and a first middle display region located at a side of the first edge display region close to the right display region; the non-display region includes a frame region surrounding at least part of the display region; the first power voltage lead is configured to provide a first power voltage and is located in the frame region; the first power voltage lead includes a lower lead extending along a portion of the lower edge corresponding to the first edge display region, and does not extend along a portion of the lower edge corresponding to the first middle display region; the first power voltage line includes an edge voltage line located in the first edge display region and a middle voltage line located in the first middle display region; the edge voltage line is directly connected to the lower lead to provide a first power voltage to sub-pixels located in the first edge display region, and the middle voltage line is spaced apart from the lower lead.

For example, in the display substrate provided by at least one embodiment of the present disclosure, the first power voltage line comprises a longitudinal voltage line extending in the longitudinal direction and a transverse voltage line extending in the transverse direction, and the longitudinal voltage line and the transverse voltage line are arranged in different layers; the longitudinal voltage line comprises an edge longitudinal voltage line located in the first edge display region, the transverse voltage line comprises an edge transverse voltage line that is located in the first edge display region and intersected with the edge longitudinal voltage line, and the edge longitudinal voltage line and the edge transverse voltage line constitute the edge voltage line; the first power voltage lead further comprises a left lead extending along the left edge of the display region, the edge longitudinal voltage line is directly connected with the lower lead, and the edge transverse voltage line is directly connected with the left lead.

For example, in the display substrate provided by at least one embodiment of the present disclosure, the sub-pixel comprises: a driving transistor, a light-emitting element and a data transistor, the driving transistor is configured to control a magnitude of a driving current flowing through the light-emitting element, the light-emitting element is configured to receive the driving current and be driven by the driving current to emit light, the data transistor is configured to write a data signal to a gate electrode of the driving transistor in response to a first control signal, and the data line is configured to transmit the data signal to the sub-pixel; the display region comprises a lower display region and an upper display region, the lower display region is close to the lower edge, and the upper display region is located at a side of the lower display region away from the lower edge in the longitudinal direction; the lower display region comprises a first region and a second region, the first region comprises a first sub-region close to the left edge and a second sub-region away from the left edge in the transverse direction, and the data line passing through the first sub-region and the second region comprises a first connection line extending in the longitudinal direction in the first sub-region and a second connection line extending in the transverse direction in the second region; the first connection line and the longitudinal voltage line are arranged in a same layer, the second connection line and the transverse voltage line are arranged in a same layer, and the first connection line and the second connection line of one same data line are electrically connected through a first connection via; the first sub-region is located in the first middle display region, and the second region is at least partially located in the middle display region; the first sub-region has a left endpoint closest to the left edge of the display region in the transverse direction, and a straight line extending in the longitudinal direction and passing through the left endpoint is a boundary between the first edge display region and the first middle display region.

For example, in the display substrate provided by at least one embodiment of the present disclosure, the boundary passes through the second region and divides the second region into a first sub-region close to the left edge of the display region and a second sub-region away from the left edge of the display region, the first sub-region is located in the first edge display region, and the second sub-region is located in the first middle display region; the lower display region further comprises a third region, the third region is located in the first edge display region and at a side of the second region away from the first region in the transverse direction; the edge transverse voltage line comprises a lower edge transverse voltage line located in the third region, the edge longitudinal voltage line passes through the third region and intersects with the lower edge transverse voltage line at a first intersection point, a left end of the lower edge transverse voltage line is electrically connected with the left lead, and a right end of the lower edge transverse voltage line opposite to the left end thereof is disconnected from the second connection line in the second region through a first opening; the longitudinal voltage line comprises a plurality of the edge longitudinal voltage lines and a plurality of the edge transverse voltage lines, the plurality of edge longitudinal voltage lines and the plurality of edge transverse voltage lines are interwoven into a mesh, and the mesh comprises a plurality of the first intersection points; at a position of each of part of the plurality of first intersection points, one edge longitudinal voltage line is electrically connected with one lower edge transverse voltage line through a first via.

For example, in the display substrate provided by at least one embodiment of the present disclosure, the plurality of edge longitudinal voltage lines are electrically connected with the plurality of edge transverse voltage lines through a plurality of the first vias, a planar pattern constituted by positions of the plurality of first vias is a connection line segment as a whole located in the third region, and an extension direction of the connection line segment intersects with both the first direction and the second direction.

For example, in the display substrate provided by at least one embodiment of the present disclosure, the third region is a corner region defined by a second edge of the second region close to the left edge in the transverse direction, the left edge and the lower edge.

For example, in the display substrate provided by at least one embodiment of the present disclosure, the frame region comprises a frame corner region surrounding the corner region, and a mesh-shaped auxiliary first power voltage line is arranged in the frame corner region, and the mesh-shaped auxiliary first power voltage line comprises: a plurality of vertical auxiliary voltage lines and a plurality of horizontal auxiliary voltage lines. The plurality of vertical auxiliary voltage lines extend in the longitudinal direction and are arranged in a same layer as the longitudinal voltage line, a first end of each of the plurality of vertical auxiliary voltage lines in the longitudinal direction is directly connected with the first power voltage lead, and a second end of each of the plurality of vertical auxiliary voltage lines opposite to the first end thereof in the longitudinal direction is electrically connected with one of the edge longitudinal voltage lines passing through the corner region; the plurality of horizontal auxiliary voltage lines extend in the transverse direction and are arranged in a same layer as the plurality of vertical auxiliary voltage lines, a first end of each of the plurality of horizontal auxiliary voltage lines in the transverse direction is directly connected with the first power voltage lead, and a second end of each of the plurality of horizontal auxiliary voltage lines in the transverse direction opposite to the first end thereof is electrically connected with one of the edge longitudinal voltage lines.

For example, in the display substrate provided by at least one embodiment of the present disclosure, the display region comprises a pixel array, the pixel array comprises a plurality of pixel rows extending in the transverse direction and a plurality of pixel columns extending in the longitudinal direction; the plurality of pixel rows comprise a plurality of edge pixel rows close to the lower edge; the plurality of horizontal auxiliary voltage lines are in one-to-one correspondence with the plurality of edge pixel rows, each edge pixel row in the plurality of edge pixel rows comprises an edge sub-pixel closest to the left edge, and the plurality of edge longitudinal voltage lines comprise an outermost edge longitudinal voltage line passing through the edge sub-pixel of the each edge pixel row; the second end of each of the plurality of horizontal auxiliary voltage lines is electrically connected with the outermost longitudinal voltage line passing through a corresponding edge pixel row, and is electrically connected with the edge transverse voltage line passing through the corresponding edge pixel row through a first edge via.

For example, in the display substrate provided by at least one embodiment of the present disclosure, the transverse voltage line further comprises a plurality of first transverse voltage lines, the plurality of first transverse voltage lines are arranged in the longitudinal direction and located in the upper display region; a left end of each of the plurality of first transverse voltage lines is electrically connected with the left lead, the plurality of edge transverse voltage lines further comprise an upper edge transverse voltage line located in the upper display region, and the upper edge transverse voltage line serves as a portion of one of the first transverse voltage lines; the longitudinal voltage line further comprises a plurality of middle longitudinal voltage lines, the plurality of middle longitudinal voltage lines are arranged in the transverse direction, pass through part of the first middle display region and pass through the upper display region along the longitudinal direction, the plurality of middle longitudinal voltage lines, the plurality of edge longitudinal voltage lines and the plurality of first transverse voltage lines are interwoven into a mesh; the plurality of edge longitudinal voltage lines intersect with the plurality of first transverse voltage lines at a plurality of auxiliary intersection points in the first edge display region, at a position of each of part of the plurality of auxiliary intersection points, one edge longitudinal voltage line is electrically connected with one first transverse voltage line through an auxiliary via; the plurality of edge longitudinal voltage lines are electrically connected with the plurality of first transverse voltage lines through a plurality of auxiliary vias; a planar pattern constituted by positions of the plurality of auxiliary vias is an auxiliary line segment as a whole located in the first edge display region, and one end of the auxiliary line segment away from the left edge is suspended.

For example, in the display substrate provided by at least one embodiment of the present disclosure, an extension direction of the auxiliary line segment is the same as the extension direction of the connection line segment; the display substrate comprises a plurality of the auxiliary line segments, and the connection line segment and the plurality of auxiliary line segments are arranged at intervals in the longitudinal direction.

For example, in the display substrate provided by at least one embodiment of the present disclosure, the display region further comprises an upper edge opposite to the lower edge, the first power voltage lead further comprises an upper lead extending along the upper edge, and the upper lead is electrically connected with the left lead; an upper end of the edge longitudinal voltage line is connected with the upper lead, and a lower end of the edge longitudinal voltage line opposite to the upper end thereof is directly connected with the lower lead; the longitudinal voltage line comprises a middle longitudinal voltage line located in the first middle display region, and the middle longitudinal voltage line comprises: a first longitudinal voltage line and a second longitudinal voltage line. The first longitudinal voltage line passes through the upper display region and at least part of the second region in sequence along the longitudinal direction, an upper end of the first longitudinal voltage line is electrically connected with the upper lead, and a lower end of the first longitudinal voltage line opposite to the upper end thereof is disconnected from the first connection line in the first sub-region through a second opening; the second longitudinal voltage line passes through the upper display region and the first region in sequence along the longitudinal direction; the transverse voltage line comprises a middle transverse voltage line located in the first region, the middle transverse voltage line is disconnected from the second connection line in the second region through a third opening, the second longitudinal voltage line intersects with the middle transverse voltage line at a second intersection point, and the second longitudinal voltage line is electrically connected with the middle transverse voltage line through a second via at the second intersection point.

For example, in the display substrate provided by at least one embodiment of the present disclosure, the plurality of first transverse voltage lines intersect with the plurality of second longitudinal voltage lines at a plurality of third intersection points, and at a position of each of at least part of the plurality of third intersection points, one first transverse voltage line is electrically connected with one second longitudinal voltage line through a third via.

For example, in the display substrate provided by at least one embodiment of the present disclosure, the display region further comprises a right edge opposite to the left edge, the first power lead further comprises a right lead extending along the right edge, and the right lead is electrically connected with the upper lead; each of the plurality of first transverse voltage lines runs through the upper display region along the transverse direction, and a right end of each of the plurality of first transverse voltage lines opposite to the left end thereof is electrically connected with the right lead.

For example, in the display substrate provided by at least one embodiment of the present disclosure, the plurality of middle longitudinal voltage lines intersect with the plurality of first transverse voltage lines at a plurality of fourth intersection points in the upper display region, and at a position of each of part of the plurality of fourth intersection points, one middle longitudinal voltage line is electrically connected with one first transverse voltage line through a fourth via; a planar pattern constituted by positions of the plurality of fourth vias is a zigzag line as a whole.

For example, in the display substrate provided by at least one embodiment of the present disclosure, the zigzag line comprises a plurality of sub-zigzag lines extending from the left edge to the right edge, and each of the plurality of sub-zigzag lines comprises a plurality of zigzag line segments connected end to end; the plurality of zigzag line segments comprise a first line segment extending in a first direction and a second line segment extending in a second direction, the first direction intersects with the second direction, both the first direction and the second direction intersect with the transverse direction and the longitudinal direction, and a first end of the first line segment intersects with a first end of the second line segment at an upper vertex; a plurality of vertices of the plurality of sub-zigzag lines are located on a second longitudinal voltage line, and the fourth vias at positions of the vertices are all the second vias.

For example, in the display substrate provided by at least one embodiment of the present disclosure, each of the plurality of sub-zigzag lines is W-shaped.

For example, in the display substrate provided by at least one embodiment of the present disclosure, the W-shaped sub-zigzag line comprises the first line segment, the second line segment, a third line segment and a fourth line segment, the first line segment and the second line segment are located between the third line segment and the fourth line segment, the third line segment is connected with the first line segment, and the fourth line segment is connected with the second line segment; the first line segment is substantially parallel to the fourth line segment, and the second line segment is substantially parallel to the third line segment.

For example, in the display substrate provided by at least one embodiment of the present disclosure, the longitudinal direction is perpendicular to the transverse direction, an included angle between the first line segment and the transverse direction is 45 degrees, and an included angle between the second line segment and the transverse direction is 45 degrees.

For example, in the display substrate provided by at least one embodiment of the present disclosure, in the longitudinal direction, the auxiliary line segment is located between the third line segments of two adjacent sub-zigzag lines.

For example, in the display substrate provided by at least one embodiment of the present disclosure, the connection line segment, the auxiliary line segment and the third line segment are substantially parallel to each other.

For example, in the display substrate provided by at least one embodiment of the present disclosure, the second longitudinal voltage line divides the first region into the first sub-region and the second sub-region, and a structure of the first sub-region and a structure of the second sub-region are substantially axially symmetrical with respect to the second longitudinal voltage line; the lower display region comprises a fourth region, and a structure of the fourth region and a structure of the second region are substantially axially symmetrical with respect to the second longitudinal voltage line; the data line passing through the first region and the fourth region comprises a third connection line extending in the longitudinal direction in the second sub-region and a fourth connection line extending in the transverse direction in the fourth region; the third connection line and the longitudinal voltage line are arranged in a same layer, the fourth connection line and the transverse voltage line are arranged in a same layer, and the third connection line and the fourth connection line of one same data line are electrically connected through a second connection via; a right end of the middle transverse voltage line located in the first region opposite to a left end thereof is disconnected from the fourth connection line in the fourth region through a fourth opening.

For example, in the display substrate provided by at least one embodiment of the present disclosure, the display substrate comprises a plurality of the first connection lines, a plurality of the second connection lines, a plurality of the third connection lines and a plurality of the fourth connection lines; the plurality of first connection lines and the plurality of second connection lines are electrically connected through a plurality of the first connection vias respectively, and the plurality of third connection lines and the plurality of fourth connection lines are electrically connected through a plurality of the second connection vias respectively; a planar pattern constituted by the plurality of first connection vias is a fif th line segment as a whole, and the fifth line segment is a boundary between the first region and the second region; a planar pattern constituted by the plurality of second connection vias is a sixth line segment as a whole, and the sixth line segment is a boundary between the first region and the fourth region; the lower display region further comprises a fifth region, a structure of the fifth region and a structure of the third region are substantially axially symmetrical with respect to the second longitudinal voltage line, and a planar pattern constituted by a plurality of fifth vias which is in the fifth region and symmetrical with the plurality of first vias is a seventh line segment as a whole; a planar pattern constituted by sequentially connecting the connection line segment, the fifth line segment, the sixth line segment and the seventh line segment is same as a planar pattern of each sub-zigzag line in the plurality of sub-zigzag lines.

For example, in the display substrate provided by at least one embodiment of the present disclosure, a planar shape of the first region is a first triangle, a planar shape of the second region is a second triangle, a first edge of the first triangle close to the left edge in the transverse direction at least partially overlaps with a first edge of the second triangle away from the left edge of the display region in the transverse direction; two lower vertices of the first triangle are located on the lower edge of the display region, and a left vertex of the two lower vertices of the first triangle close to the left edge is the left endpoint of the first sub-region; the first triangle is an isosceles triangle, and the second longitudinal voltage line is substantially a perpendicular bisector of a bottom edge of the isosceles triangle.

For example, in the display substrate provided by at least one embodiment of the present disclosure, the frame region comprises a left frame region extending along the left edge, a plurality of auxiliary connection lines extending in the transverse direction are arranged in the left frame region, and the plurality of auxiliary connection lines are arranged in a same layer as the edge longitudinal voltage line; the display region comprises a pixel array, the pixel array comprises a plurality of pixel rows extending in the transverse direction and a plurality of pixel columns extending in the longitudinal direction; the plurality of pixel columns comprise an edge pixel column closest to the left edge, and the plurality of edge longitudinal voltage lines comprise an outer edge longitudinal voltage line passing through the edge pixel column; a left end of each of the plurality of auxiliary connection lines in the transverse direction is electrically connected with the left lead, and a right end of each of the plurality of auxiliary connection lines opposite to the left end thereof in the transverse direction is electrically connected with the outer edge longitudinal voltage line, and is electrically connected with a left end of a corresponding first transverse voltage line through a second edge via.

For example, in the display substrate provided by at least one embodiment of the present disclosure, the right display region comprises a second edge display region extending along the right edge and a second middle display region located at a side of the second edge display region close to the left display region; the second edge display region and the first edge display region are symmetrical with respect to an axis of symmetry extending in the longitudinal direction, and the second middle display region and the first middle display region are axially symmetrical with respect to the second longitudinal voltage line.

For example, in the display substrate provided by at least one embodiment of the present disclosure, the display substrate further comprises: a second power voltage line configured to provide a second power voltage different from the first power voltage to the sub-pixels; the longitudinal voltage line is arranged in a same layer as the data line in the upper display region, and the transverse voltage line is arranged in a same layer as the second power voltage line.

At least one embodiment of the present disclosure further provides a display device which includes any one of the display substrates provided by the embodiments of the present disclosure.

### BRIEF DESCRIPTION OF DRAWINGS

In order to clearly illustrate the technical solution of the embodiments of the disclosure, the drawings of the embodiments will be briefly described in the following; it is obvious that the described drawings are only related to some embodiments of the disclosure and thus are not limitative of the disclosure.
FIG. 1 is an overall planar view of a display substrate according to an embodiment of the present disclosure;
FIG. 2 is a partial enlarged view including the lower display region and part of the upper display region in FIG. 1;
FIG. 3A is a partial enlarged view of the region R1 in FIG. 2;
FIGS. 3B-3D are schematic diagrams of part of layers in the region R3 in FIG. 2;
FIG. 4 is a partial enlarged view including the region R2 and the region R3 in FIG. 1;
FIG. 5A is a partial enlarged view of the region R2 in FIG. 4;
FIGS. 5B-5D are schematic diagrams of part of layers in the region R2 in FIG. 4;
FIG. 6A is a partial enlarged view of the region R3 in FIG. 4;
FIGS. 6B-6D are schematic diagrams of part of layers in the region R3 in FIG. 4;
FIG. 7A is a partial enlarged view of the region R4 in FIG. 3;
FIGS. 7B-7D are schematic diagrams of part of layers in the region R4 in FIG. 3;
FIG. 8A is a partial enlarged view of the region R5 in FIG. 3;
FIGS. 8B-8C are schematic diagrams of part of layers in the region R5 in FIG. 3;
FIG. 9 is a partial enlarged view of the region R6 in FIG. 3;
FIG. 10 is an equivalent circuit diagram of a pixel circuit according to an embodiment of the present disclosure;
FIGS. 11A-11H are schematic diagrams including different layers in a pixel circuit;
FIG. 11I is a schematic diagram of a stack of the layers shown in FIGS. 11A-11H; and
FIG. 12 is a schematic diagram of a display substrate according to an embodiment of the present disclosure.

### DETAILED DESCRIPTION

In order to make objects, technical details and advantages of the embodiments of the disclosure apparent, the technical solutions of the embodiments will be described in a clearly and fully understandable way in connection with the drawings related to the embodiments of the disclosure. Apparently, the described embodiments are just a part but not all of the embodiments of the disclosure. Based on the described embodiments herein, those skilled in the art can obtain other embodiment (s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "left," "right" and the like are only used to indicate relative position relationship, and when the position of the object which is described is changed, the relative position relationship may be changed accordingly.

The drawings in the present disclosure are not drawn strictly according to the actual scale. The number of horizontal voltage lines, vertical voltage lines, and vias in the display substrate is not limited to the number shown in the drawings. The specific size and the number of each structure can be determined according to actual needs. The drawings described in the present disclosure are only structural views

The features "parallel", "perpendicular" and "same", etc., used in the embodiments of the present disclosure all include features such as "parallel", "perpendicular" and "same", etc., in the strict sense, and the cases having certain errors, such as "approximately parallel", "approximately perpendicular", "substantially the same", etc., taking into account measurements and errors associated with the measurement of a particular quantity (e.g., limitations of the measurement system), and indicate being within an acceptable range of deviation for a particular value as determined by one of ordinary skill in the art. For example, "approximately" may indicate being within one or more standard deviations, or within 10% or 5% of the stated value.

In the case that the quantity of a component is not specifically indicated below in the embodiments of the present disclosure, it means that the component may be one or more, or may be understood as at least one. "At least one" means one or more, and "plurality" means at least two.

The term "same layer" in the embodiments of the present disclosure refers to the relationship between a plurality of layers formed of the same material through the same step (e.g., one-step patterning process). The term "same layer" herein does not always mean that the plurality of layers have the same thickness or that the plurality of layers have the same height in the cross-sectional view.

The wording indicating directions, such as "vertical", "horizontal", "upper", "lower", "left" and "right" used in the present disclosure are only used to express relative positional relationships. When the absolute position of the described object changes, the relative positional relationship may also change accordingly, and is not limited to the direction shown in the drawings of the specification. For example, the "upper edge", "lower edge", "left edge" and "right edge" are not limited to upper, lower, left and right as shown in the drawings, as long as the relative positional relationships defined therebetween are satisfied. The terms "left display region" and "right display region" are not limited to left and right in the drawings of the specification of the present application, as long as the relative positional relationship defined therebetween is satisfied. The terms "upper display region" and "lower display region" are not limited to left and right in the drawings of the specification of the present application, as long as the relative positional relationship defined therebetween is satisfied.

At least one embodiment of the present disclosure provides a display substrate, which includes: a display region, a non-display region, a first power voltage lead and a first power voltage line. The display region is provided with sub-pixels, and has a lower edge extending in a transverse direction and a left edge extending in a longitudinal direction, the transverse direction intersects with the longitudinal direction, a division line extending in the longitudinal direction divides the display region into a left display region and a right display region, and the left display region includes a first edge display region extending along the left edge and a first middle display region located at a side of the first edge display region close to the right display region; the non-display region includes a frame region surrounding at least part of the display region; the first power voltage lead is configured to provide a first power voltage and is located in the frame region; the first power voltage lead includes a lower lead extending along a portion of the lower edge corresponding to the first edge display region, and does not extend along a portion of the lower edge corresponding to the first middle display region; the first power voltage line includes an edge voltage line located in the first edge display region and a middle voltage line located in the first middle display region; the edge voltage line is directly connected to the lower lead to provide a first power voltage to sub-pixels located in the first edge display region, and the middle voltage line is spaced apart from the lower lead.

At least one embodiment of the present disclosure further provides a display device which includes any one of the display substrates provided by the embodiments of the present disclosure.

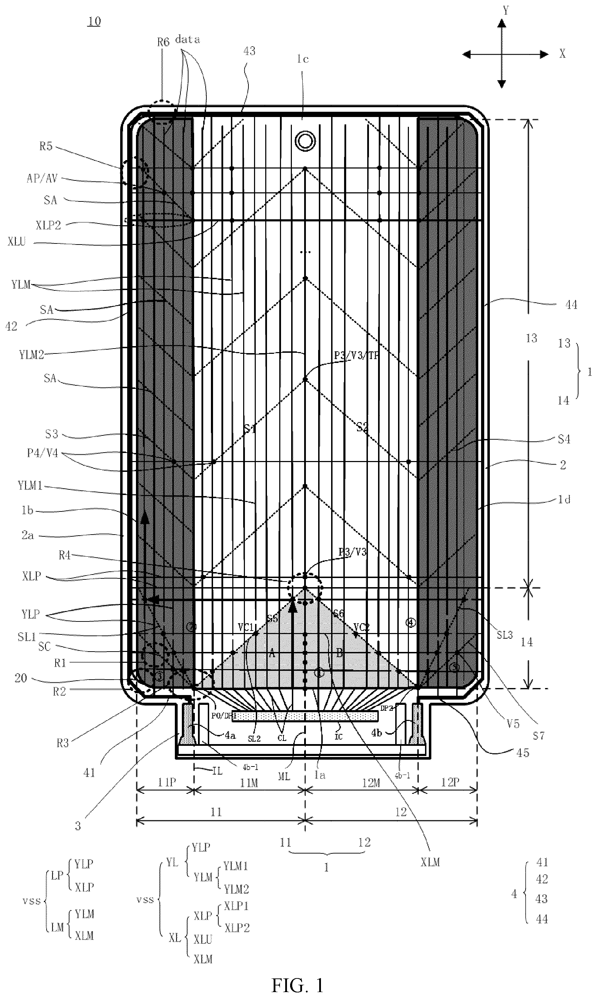

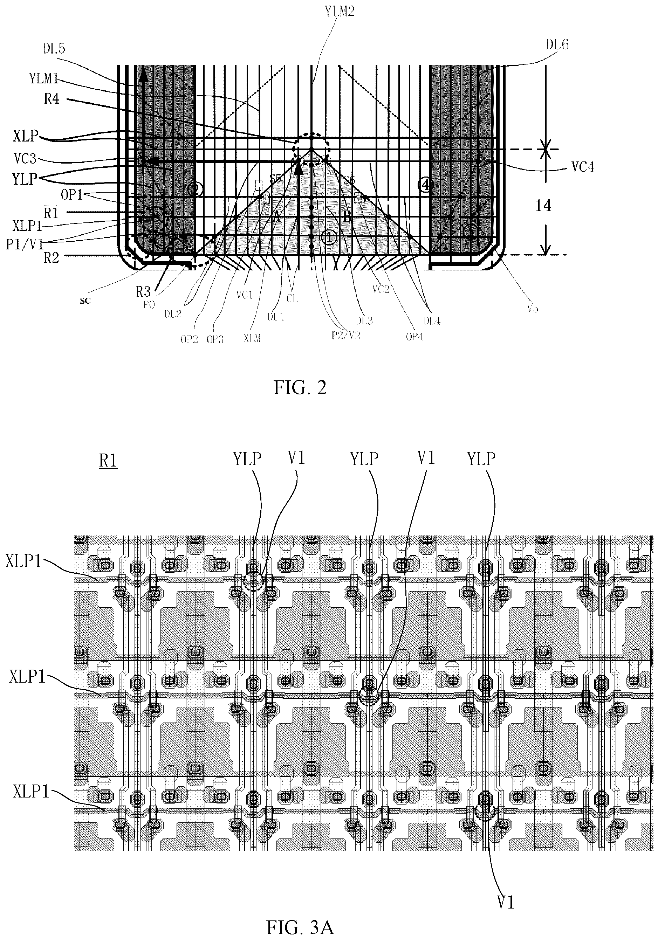

Illustratively, FIG. 1 is an overall planar view of a display substrate according to an embodiment of the present disclosure, and FIG. 2 is a partial enlarged view including the lower display region and part of the upper display region in FIG. 1. For example, as shown in FIG. 1, the display substrate 10 provided by at least one embodiment of the present disclosure includes a display region 1, a frame region 2, a first power voltage lead 4 and a first power voltage line vss. The display region 1 is provided with sub-pixels, and has a lower edge 1a extending in the transverse direction X and a left edge 1b extending in the longitudinal direction Y, the transverse direction intersects with the longitudinal direction, and for example, the transverse direction is perpendicular to the longitudinal direction; of course, in some other embodiments, the transverse direction may not be perpendicular to the longitudinal direction. The display region 1 includes a left display region 11 and a right display region 12 arranged in the transverse direction X. For example, the display region 1 is divided into the left display region 11 and the right display region 12 by a division line ML extending in the longitudinal direction Y; for example, the division line ML is the perpendicular bisector of the lower edge 1a, so that the left display region 11 and the right display region 12 are symmetrical and the display effect of the whole display substrate 10 is uniform; but it is not limited to the case in which the division line ML is the perpendicular bisector of the lower edge 1a. The left display region 11 includes a first edge display region 11P extending along the left edge 1b and a first middle display region 11M located at a side of the first edge display region 11P close to the right display region 12; the frame region 2 is a non-display region and surrounds at least part of the display region 1. For example, the display substrate 10 may further include a pad 3, and the pad 3 is located at a side of the lower edge 1a away from the display region 1; the first power voltage lead 4 is connected with the pad 3 so as to be configured to provide a first power voltage VSS, and is located in the frame region 2; the first power voltage lead 4 includes a lower lead 41 extending along a portion of the lower edge 1a corresponding to the first edge display region 11P, and does not extend along a portion of the lower edge 1a corresponding to the first middle display region 11M; the first power voltage line vss includes an edge voltage line LP located in the first edge display region 11P and a middle voltage line LM located in the first middle display region 11M, the edge voltage line LP is in contact with the lower lead 41 so as to be electrically connected to the lower lead 41 to provide the first power voltage VSS to the sub-pixels located in the first edge display region 11P, and the middle voltage line LM is spaced apart from the lower lead 41, that is, the middle voltage line LM is not directly connected with the lower lead 4 from the pad 3. In this way, in the display substrate 10 provided by the embodiment of the present disclosure, the edge voltage line is in contact with the lower lead 41, so as to be electrically connected to the lower lead 41 to provide the signal VSS to the sub-pixels in the first edge display region 11P, the middle voltage line LM is spaced apart from, that is, not in contact with, the lower lead 41, but is connected with a left lead 42 or an upper lead 43 or other first power voltage line vss to provide the signal VSS to the first middle display region 11M; that is, the first power voltage lead 4 led out from the pad 3 at a side of the lower edge 1a away from the display region is not directly connected into the first middle display region 11M, that is, the middle voltage line LM is not connected to the pad 3 through the frame region 2, is not directly connected to the first power voltage line vss, does not obtain the first power voltage VSS through the pad 3, but obtains the first power voltage VSS through the edge voltage line, thereby reducing the number of wires arranged in the fan-out region, further reducing the area of the fan-out region to reduce the width of the lower frame, and further achieving a narrower frame.

For example, the edge voltage line LP is directly connected with the lower lead 41, that is, the edge voltage line LP and the lower lead 41 are in contact with each other, and there is no any other structure between the edge voltage line LP and the lower lead 41 as a medium for connecting the two. For example, the edge voltage line LP and the lower lead 41 are arranged in the same layer and constitute a continuous integral structure; in this case, the edge voltage line LP and the lower lead 41 are made of the same material and can be formed by one same patterning process, so that the structure and manufacturing process of the display substrate can be simplified.

Of course, in other embodiments, the edge voltage line LP and the lower lead 41 may be arranged in different layers, and they are in contact with each other through a via. It should be noted that in the present disclosure, the term "directly connected" means that two structures directly connected to each other (for example, the edge voltage line LP is directly connected to the lower lead 41, etc.) are in contact with each other, and there is no any other structure between the two structures connected to each other as a medium for connecting the two. For example, two structures directly connected with each other may be a continuous integral structure, and in this case, the two structures directly connected with each other are made of the same material, and the two structures can be formed by one same patterning process to simplify the manufacturing process of the display substrate; alternatively, two structures directly connected with each other may also be made of different materials, and for example, the two structures directly connected with each other are both conductive signal lines, and the materials matching their functions can be adopted respectively to meet the needs of different performances, such as different conductivities.

For example, as shown in FIG. 1, the first power voltage line vss includes a longitudinal voltage line YL extending in the longitudinal direction Y and a transverse voltage line XL extending in the transverse direction X, and the longitudinal voltage line YL and the transverse voltage line XL are arranged in different layers; the longitudinal voltage line YL includes an edge longitudinal voltage line YLP located in the first edge display region 11P, the transverse voltage line XL includes an edge transverse voltage line XLP which is located in the first edge display region 11P and intersected with the edge longitudinal voltage line YLP, and the edge longitudinal voltage line YLP and the edge transverse voltage line XLP constitute the edge voltage line LP; the first power voltage lead 4 further includes a left lead 42 extending along the left edge 1b of the display region 1, the edge longitudinal voltage line YLP is directly connected with the lower lead 41, and the edge transverse voltage line XLP is directly connected with the left lead 42. For example, the edge longitudinal voltage line YLP runs through the entire display region in the longitudinal direction in the first edge display region 11P, so as to provide the first power voltage VSS to the sub-pixels of the entire first edge display region 11P. In this way, the edge longitudinal voltage line YLP is directly connected with the lower lead 41 close to the edge longitudinal voltage line YLP, which can save space and help to reduce the frame region at the outer side of the lower edge 1a.

For example, a No. 1 first power voltage pin 4a is arranged on the pad 3, the lower lead 41 is electrically connected with the first power voltage pin 4a, and the first power voltage pin 4a is located at a first end of the pad 3 close to the first edge display region 11P in the transverse direction X, therefore, the first power voltage pin 4a, the lower lead 41 and the edge longitudinal voltage line YLP in the first edge display region 11P are directly connected sequentially in the nearby, which can effectively reduce the wiring of the lower frame and reduce the area of the frame region at the outer side of the lower edge 1a.

For example, as shown in FIG. 1, in some embodiments, a No.2 first power voltage pin 4b may be further arranged on the pad 3, and the No.2 first power voltage pin 4b is close to the right edge 1d, that is, it is located at a second end of the pad 3 close to a lower second edge display region 12P described below in the transverse direction X; and the structures related to the first power voltage line vss in the second edge display region 12P and the first edge display region 11P are axially symmetrical with respect to a symmetry axis extending in the longitudinal direction Y. Similar to the connection of the No. 1 first power voltage pin 4a and the first power voltage line vss in the first edge display region 11P, the No.2 first power voltage pin 4b is directly connected to the edge longitudinal voltage line in the second edge display region 12P to provide the first power voltage VSS to the sub-pixels in the second edge display region 12P.

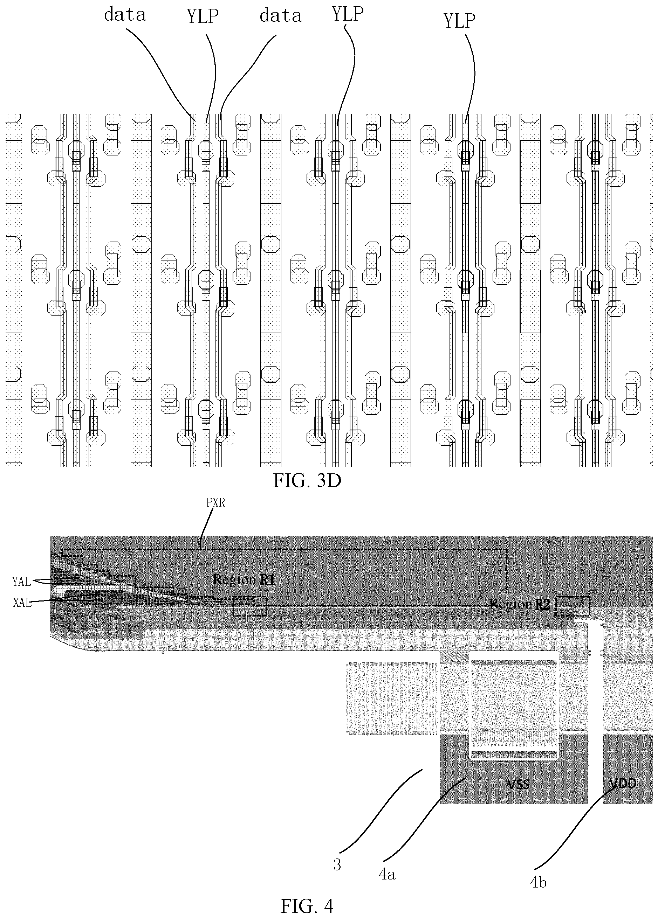

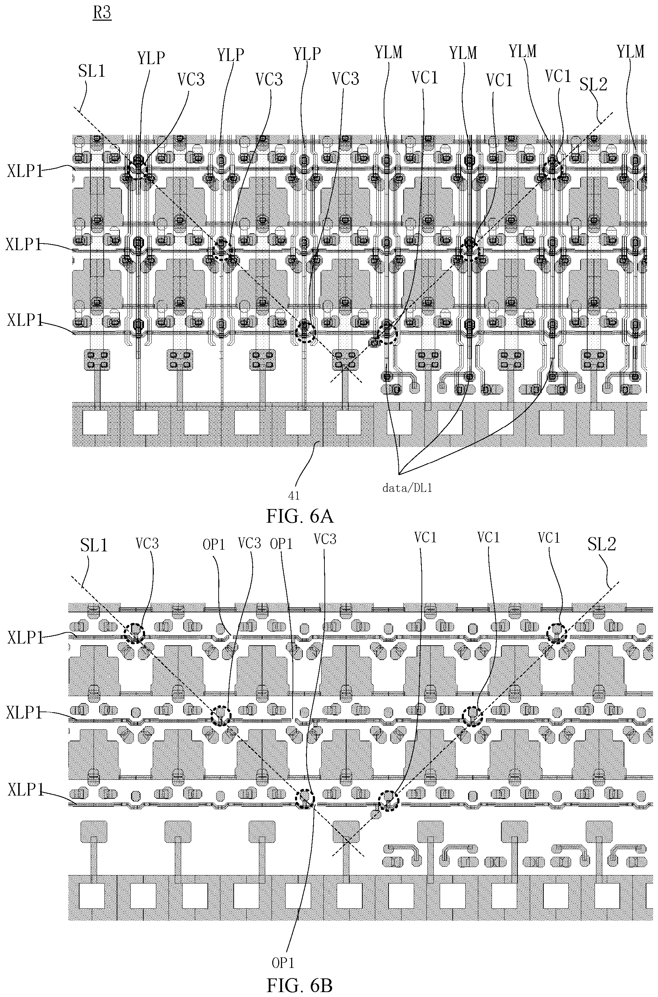

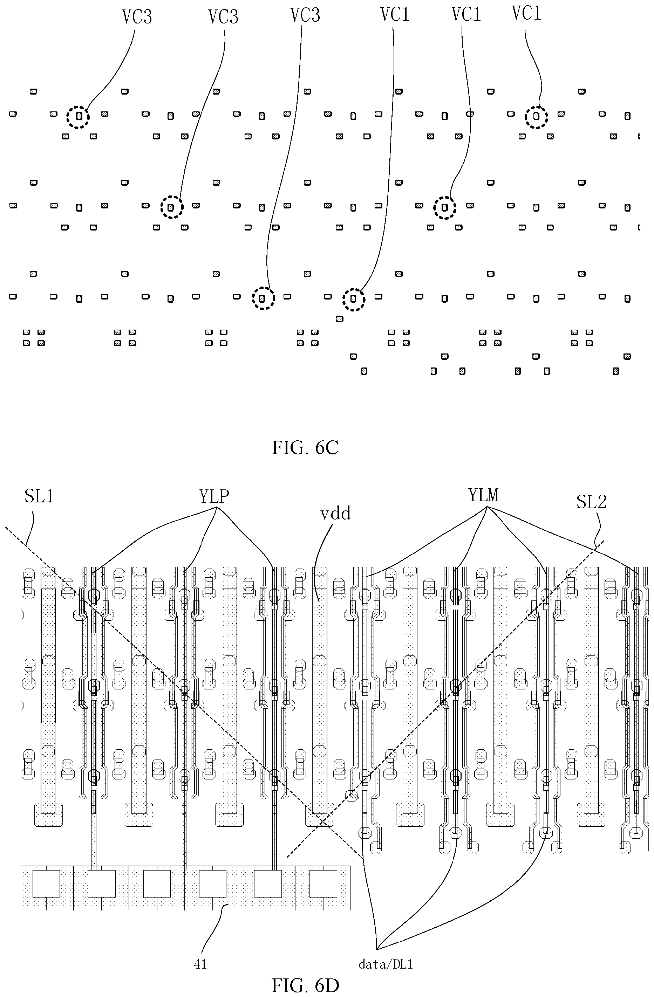

FIG. 6A is a partial enlarged view of the region R3 in FIG. 4, and FIGS. 6B-6D are schematic diagrams of part of layers in the region R3 in FIG. 4. For example, as shown in FIGS. 1 and 6A, the lower end of the edge longitudinal voltage line YLP close to the lower lead 41 is directly connected with the lower lead 41. For example, the upper end of the edge longitudinal voltage line YLP opposite to the lower end thereof is directly connected with the upper lead 43, so as to provide the first power voltage VSS through the edge longitudinal voltage line YLP more reliably.

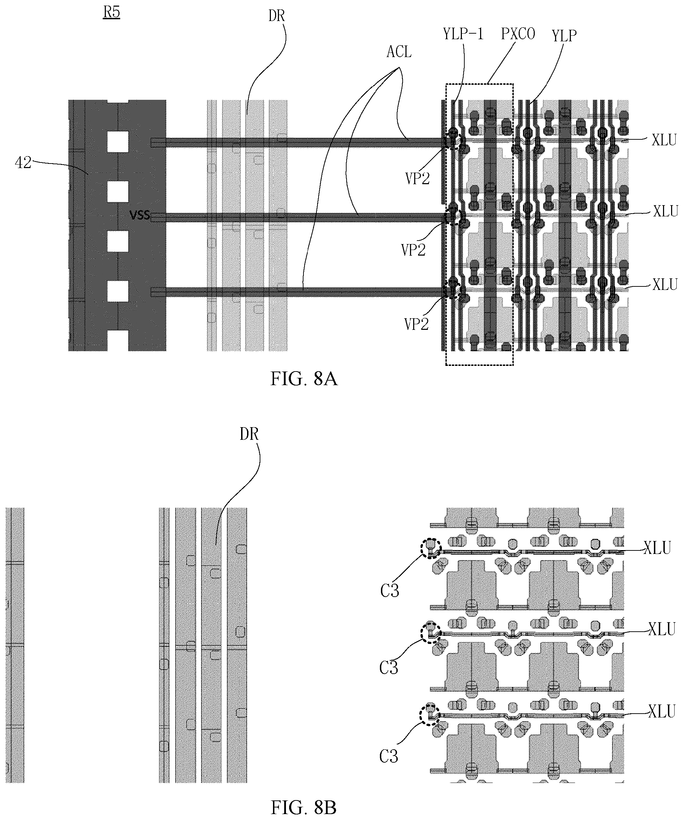

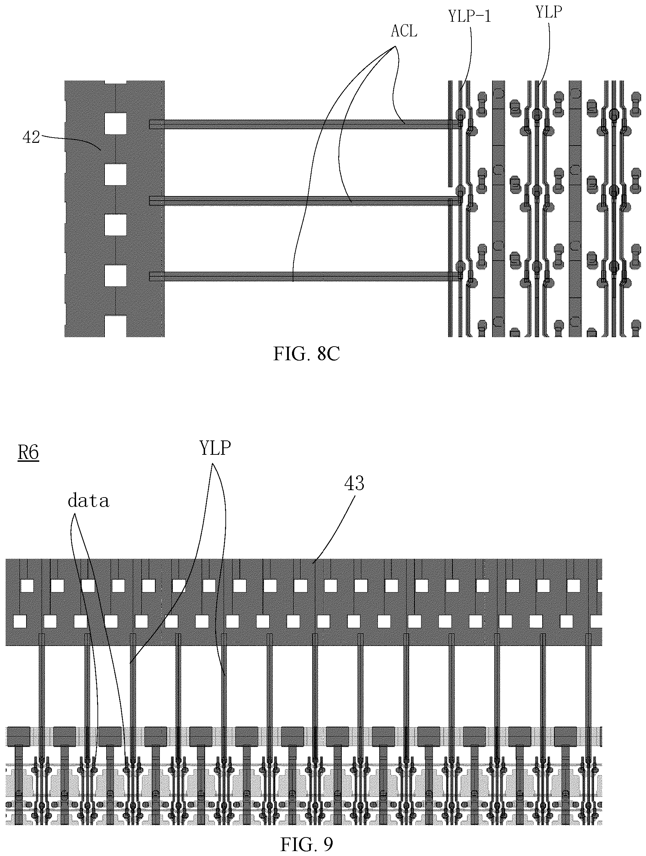

For example, as shown in FIG. 1, combined with the equivalent circuit diagram of the pixel circuit shown in FIG. 8, the display substrate 10 further includes a data line *data,* and the sub-pixel includes a driving transistor T3, a light-emitting element and a data transistor T4. The driving transistor T3 is configured to control the magnitude of a driving current flowing through the light-emitting element, the light-emitting element is configured to receive the driving current and be driven by the driving current to emit light, the data transistor T4 is configured to write a data signal DATA into the gate electrode of the driving transistor T3 in response to a first control signal, and the data line *data* is configured to transmit the data signal DATA to the sub-pixel; the display region 1 includes a lower display region 14 and an upper display region 13, the lower display region 14 is close to the lower edge 1a, and the upper display region 13 is located at a side of the lower display region 14 away from the lower edge 1a in the longitudinal direction; the lower display region 14 includes a first region ① and a second region ②, the first region ① includes a first sub-region A close to the left edge 1b and a second sub-region B away from the left edge 1b in the transverse direction X, the data line *data* passing through the first sub-region A and the second region ② includes a first connection line DL1 extending in the longitudinal direction Y in the first sub-region A, a second connection line DL2 extending in the transverse direction X in the second region ②, and a fifth connection line DL5 extending in the longitudinal direction Y in the upper display region 13, and the first connection line DL5 and the first connection line DL1 are arranged in a same layer; the first connection line DL1 and the longitudinal voltage line YL are arranged in a same layer, the second connection line DL2 and the transverse voltage line XL are arranged in a same layer, the first connection line DL1 and the second connection line DL2 of the same data line *data* are electrically connected through a first connection via VC1, and the fifth connection line DL5 and the second connection line DL2 of the same one data line *data* are electrically connected through a third connection via VC3. Thus, for one data line *data,* a transmission path of the data signal DATA as indicated by three arrows in FIG. 1 is formed. For example, a plurality of data lines *data* are connected with the pad 3 through a plurality of data signal leads CL, respectively, and for example, electrically connected with an integrated circuit IC in the pad 3, so as to provide data signals DATA to the data lines *data.*

For example, the first sub-region A is located in the first middle display region 11M, and the second region ② is at least partially located in the first middle display region 11M; the first sub-region A has a left endpoint PO closest to the left edge 1b of the display region 1 in the transverse direction X, and a straight line extending in the longitudinal direction Y and passing through the left endpoint PO is the boundary IL between the first edge display region 11P and the first middle display region 11M. That is, the region between this straight line and the left edge 1b is the first edge display region 11P. The first sub-region A is located in the first middle display region 11M.

For example, as shown in FIGS. 1-2, the boundary IL passes through the second region ② and divides the second region (2) into a first sub-region A close to the left edge 1b of the display region 1 and a second sub-region B away from the left edge 1b of the display region 1, the first sub-region A is located in the first edge display region 11P, and the second sub-region B is located in the first middle display region 11M.

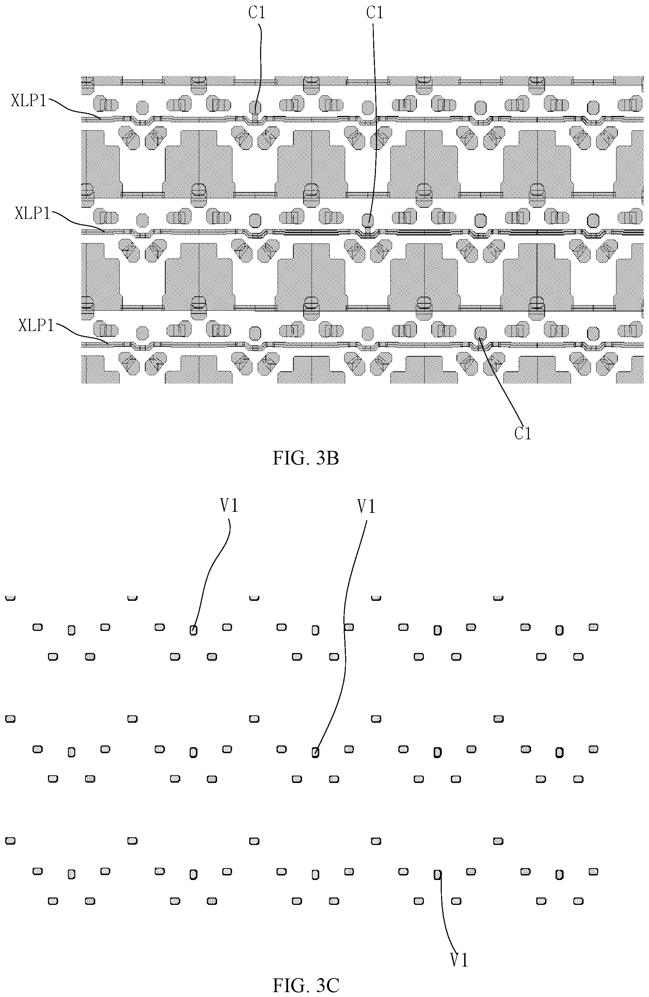

FIG. 3A is a partial enlarged view of the region R1 in FIG. 2, and FIGS. 3B-3D are schematic diagrams of part of layers in the region R3 in FIG. 2. With reference to FIGS. 1-2 and 3A-3D, or with reference to FIGS. 1 and 6A-6D, the lower display region 14 further includes a third region ③, and the third region ③ is located in the first edge display region 11P and at a side of the second region (2) away from the first region ① in the transverse direction X; the edge transverse voltage line XLP includes a lower edge transverse voltage line XLP1 located in the third region ③, the edge longitudinal voltage line YLP passes through the third region ③ and intersects with the lower edge transverse voltage line XLP1 at a first intersection point P1, the left end of the lower edge transverse voltage line XLP1 is electrically connected with the left lead 42, and the right end of the lower edge transverse voltage line XLP1 opposite to the left end thereof is disconnected from the second connection line DL2 passing through the second region ② through a first opening OP1. The first opening OP1 can be referred to FIGS. 1-2, and FIGS. 3A-3B are partial views showing only a few pixels, so the first opening OP1 is not shown in FIGS. 3A-3B. The longitudinal voltage lines YL include a plurality of edge longitudinal voltage lines YLP and a plurality of edge transverse voltage lines XLP, the plurality of edge longitudinal voltage lines YLP and the plurality of edge transverse voltage lines XLP are interwoven into a mesh, and the mesh includes a plurality of first intersection points P1; at the position of each of part of the plurality of first intersection points P1, one edge longitudinal voltage line YLP is electrically connected with one lower edge transverse voltage line XLP1 through a first via V1, so that a plurality of first vias V1 exist at the plurality of first intersection points P1. In this way, the plurality of edge longitudinal voltage lines YLP and the plurality of lower edge transverse voltage lines XLP1 are electrically connected in the third region ③ to form a mesh structure, so that the resistance of the first power voltage line vss transmitting the first power voltage VSS in the third region ③ can be reduced, and the voltage drop on the meshed first power voltage line vss formed of the edge longitudinal voltage lines YLP and the lower edge transverse voltage lines XLP1 in the third region ③ is relatively low.

For example, there is a first insulation layer between the layer shown in FIG. 4B and the layer shown in FIG. 4C, the first via V1 penetrates through the first insulation layer, and the edge longitudinal voltage line YLP is electrically connected with the lower edge transverse voltage line XLP1 through a first connection structure C1 passing through the first via V1.

For example, all the first power voltage lines vss extending in the longitudinal direction Y in the display region 1 (longitudinal voltage lines YL) are arranged in the same layer as the data lines *data* in the upper display region 13, and the transverse voltage lines XL located in the display region 1 are arranged in the same layer as the second power voltage line; all the first power voltage lines vss extending in the X direction (transverse voltage lines XL) are located at a side of the longitudinal voltage lines YL close to the base substrate. For example, the longitudinal voltage line YL is located in the sixth conductive layer 580 described below, and the transverse voltage line XL is located in the fifth conductive layer 570 described below. Of course, in other embodiments, it is not limited to this case, as long as the longitudinal voltage line YL and the transverse voltage line XL are arranged in different metal layers; and a first insulation layer is arranged between the two metal layers.

FIGS. 3A-3B show three first vias V1 as an example, but the number of the first vias V1 is not limited to three.

For example, referring to FIGS. 1-2, the plurality of edge longitudinal voltage lines YLP are electrically connected with the plurality of edge transverse voltage lines XLP through a plurality of first vias V1, and the planar pattern constituted by the positions of the plurality of first vias V1 is a connection line segment SC as a whole located in a third region ③ (the dashed line in the third region ③ in FIG. 1 represents the connection line segment SC), and the extension direction of the connection line segment SC intersects with both the transverse direction X and the longitudinal direction Y. Here, "the planar pattern constituted by the positions of the plurality of first vias V1" refers to an overall pattern constituted by the positions of the plurality of first vias V1.

For example, in the embodiment shown in FIGS. 1-2, the connection line segment SC is a straight line segment, so as to be consistent with the shape of the W-shaped zigzag line hereinafter. Of course, in other embodiments, the connection line segment SC can also be a curved line segment if necessary.

For example, as shown in FIG. 1, the third region ③ is a corner region defined by a first edge SL1 of the second region ② close to the left edge 1b in the transverse direction X, the left edge 1b and the lower edge 1a. The third region ③ is the corner region, and the first power voltage signal can be connected to the floating wires in the corner region which were originally floating due to the design (Fan-out In Pixel, FIP technology) of setting the first opening OP1 to achieve data lines Data passing through the second region (2) and the first region ①, so as to prevent the signal interference caused by these floating wires. For example, the floating wires are easy to accumulate static electricity and cause electrostatic interference.

The planar pattern of the plurality of third connection vias VC3 respectively used to connect the fifth connection lines DL5 and the second connection lines DL2 of a plurality of data lines *data* is a line segment as a whole, such as a straight line segment; and the line segment serves as the first edge SL1 of the second region ② and also serves as the boundary between the third region ③ and the second region ②.

For example, referring to FIGS. 1-2, the frame region 2 includes a frame corner region 20 surrounding the corner region ③, a mesh-shaped auxiliary first power voltage line vss is arranged in the frame corner region 20, so that the voltage drop on the first power voltage line in the first edge display region 11P can be greatly reduced.

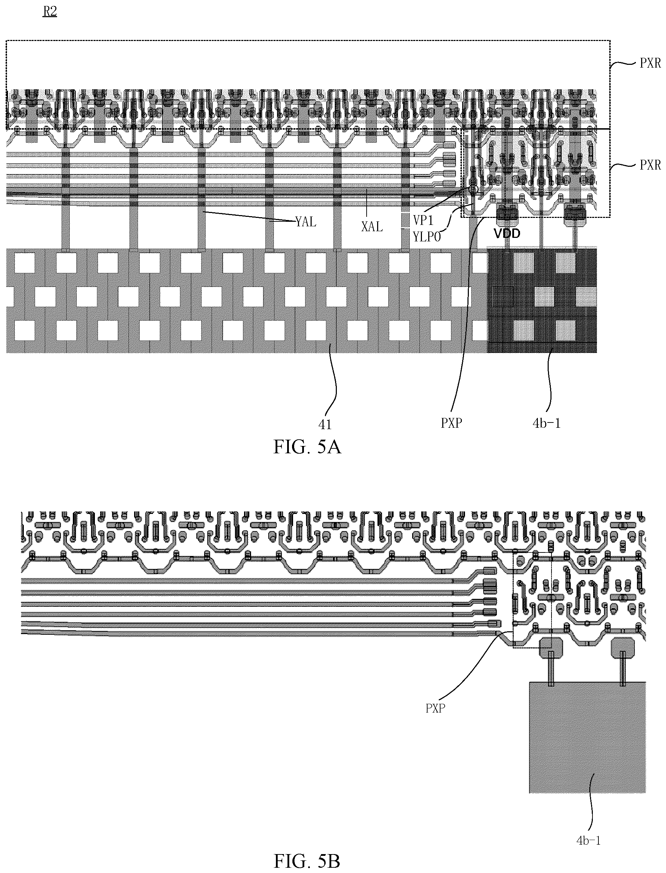

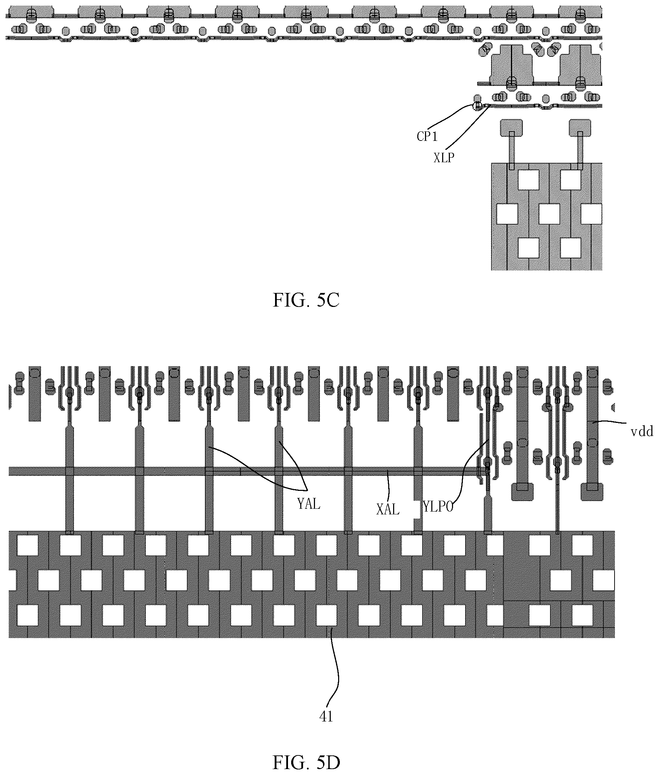

FIG. 4 is a partial enlarged view including the region R2 and the region R3 in FIG. 1, and the region R2 includes the frame corner region 20; FIG. 5A is a partial enlarged view of the region R2 in FIG. 4, and FIGS. 5B-5D are schematic diagrams of part of layers in the region R2 in FIG. 4. With reference to FIGS. 4 and 5A-5D, the mesh-shaped auxiliary first power voltage line vss includes a plurality of vertical auxiliary voltage lines YAL and a plurality of horizontal auxiliary voltage lines XAL. The plurality of vertical auxiliary voltage lines YAL extend in the longitudinal direction Y and are arranged in the same layer as the longitudinal voltage line YL, wherein a first end of each of the plurality of vertical auxiliary voltage lines YAL in the longitudinal direction Y is directly connected with the first power voltage lead 4 (e.g., the lower lead 41 or a corner lead connecting the lower lead 41 and the left lead 42), and a second end of each of the plurality of vertical auxiliary voltage lines YAL opposite to the first end thereof in the longitudinal direction Y is electrically connected, for example, directly connected, with one edge longitudinal voltage line YLP passing through the corner region ③; the plurality of horizontal auxiliary voltage lines XAL extend in the transverse direction X and are arranged in the same layer as the plurality of vertical auxiliary voltage lines YAL, wherein a first end of each of the plurality of horizontal auxiliary voltage lines XAL in the transverse direction X is directly connected with the first power voltage lead 4 (e.g., the left lead 42 or a corner lead connecting the lower lead 41 and the left lead 42), and a second end of each of the plurality of horizontal auxiliary voltage lines XAL in the transverse direction X opposite to the first end thereof is electrically connected with one edge longitudinal voltage line YLP. As shown in FIG. 5D, the plurality of vertical auxiliary voltage lines YAL and the plurality of horizontal auxiliary voltage lines are arranged in a same layer, for example, in the same layer as the longitudinal voltage lines YL; and the vertical auxiliary voltage lines YAL, the horizontal auxiliary voltage lines and the longitudinal voltage lines YL can be formed at the same time by a same patterning process, so as to simplify the structure and manufacturing process of the display substrate.

For example, referring to FIGS. 5A-5D, the display region 1 includes a pixel array, the pixel array includes a plurality of pixel rows extending in the transverse direction X and a plurality of pixel columns extending in the longitudinal direction Y; the plurality of pixel rows includes a plurality of edge pixel rows PXR close to the lower edge 1a; the plurality of horizontal auxiliary voltage lines XAL are in one-to-one correspondence with the plurality of edge pixel rows PXR, each edge pixel row PXR in the plurality of edge pixel rows PXR includes an edge sub-pixel P closest to the left edge 1b, and the plurality of edge longitudinal voltage lines YLP include an outermost edge longitudinal voltage line YLP0 passing through the edge sub-pixel P of the each edge pixel row PXR; the second end of each of the plurality of horizontal auxiliary voltage lines XAL is electrically connected, for example, directly connected, with the outermost longitudinal voltage line YLP0 passing through a corresponding edge pixel row PXR; and the second end of each of the plurality of horizontal auxiliary voltage lines XAL is electrically connected with the edge transverse voltage line XLP passing through the corresponding edge pixel row PXR through a first edge via VP1. As shown in FIG. 5C, the second end of the horizontal auxiliary voltage line XAL is electrically connected with the edge transverse voltage line XLP passing through the corresponding edge pixel row PXR through a first edge connection structure CP1 penetrating through the first insulation layer. FIGS. 5A-5D show the connection relationship between a horizontal auxiliary voltage line XAL and a corresponding edge pixel row PXR closest to the lower edge 1a, and the other edge pixel rows PXR are connected in the same way, except that in the present embodiment, the length of the horizontal auxiliary voltage line XAL corresponding to each edge pixel row PXR is different in order to adapt to the shape of the corner region. In other embodiments, if necessary, the length of the horizontal auxiliary voltage line XAL of each edge pixel row PXR can also be designed to adapt to the pixel arrangement of the display substrate.

For example, as shown in FIGS. 1 and 5A-5B, the second power voltage lead 4b-1 is located in the lower frame region surrounding the lower edge 1a, and is electrically connected with the second power voltage pin 4b; the second power voltage line passing through a plurality of pixel columns is electrically connected with the second power voltage lead 4b-1, thereby providing a second power voltage VDD to the pixels of the plurality of pixel columns.

For example, as shown in FIG. 1, the transverse voltage line XL further includes a plurality of first transverse voltage lines XLU, and the plurality of first transverse voltage lines XLU are arranged in the longitudinal direction Y and located in the upper display region 13; the left ends of the first transverse voltage lines XLU are electrically connected with the left lead 42, the edge transverse voltage lines XLP further include an upper edge transverse voltage line XLP2 located in the upper display region 13, and the upper edge transverse voltage line XLP2 serves as a portion of one first transverse voltage line XLU. The longitudinal voltage line YL further includes a plurality of middle longitudinal voltage lines YLM, and the plurality of first transverse voltage lines XLU are arranged in the transverse direction X, and pass through part of the first middle display region 11M and pass through the upper display region 13 in the longitudinal direction Y; the plurality of middle longitudinal voltage lines YLM, the plurality of edge longitudinal voltage lines YLP and the plurality of first transverse voltage lines XLU are interwoven into a mesh, so as to reduce the resistance of the first power voltage line vss and reduce the voltage drop on the first power voltage line vss.

The plurality of edge longitudinal voltage lines YLP intersect with the plurality of first transverse voltage lines XLU at a plurality of auxiliary intersection points AP in the first edge display region 11P; at the position of each of part of the plurality of auxiliary intersection points AP, one edge longitudinal voltage line YLP is electrically connected with one first transverse voltage line XLU through an auxiliary via AV in the first edge display region 11P; the plurality of edge longitudinal voltage lines YLP are electrically connected with the plurality of first transverse voltage lines XLU through a plurality of auxiliary vias AV; the planar pattern constituted by the positions of the plurality of auxiliary vias AV is an auxiliary line segment SA as a whole located in the first edge display region 11P, and one end of the auxiliary line segment SA away from the left edge 1b is suspended, that is, no other via pattern is connected with the end of the auxiliary line segment SA away from the left edge 1b, and the auxiliary line segment SA is different from the third line segment S3 of a W-shaped zigzag line described below. In this way, the resistance of the first power voltage line vss in the first edge display region 11P can be further effectively reduced, and the voltage drop on the first power voltage line vss in the first edge display region 11P can be reduced.

At the position of the auxiliary line segment SA, one edge longitudinal voltage line YLP is electrically connected with one first transverse voltage line XLU through an auxiliary via AV in the first edge display region 11P, which is the same as the structure of the region R1 shown in FIGS. 3A-3D. FIGS. 3A-3D can be referred to, which is not repeated here.

For example, referring to FIG. 1, the extension direction of the auxiliary line segment SA is the same as the extension direction of the connection line segment SC; for example, the lengths of the auxiliary line segment SA and the connection line segment SC are also the same, so as to maintain the uniformity of the arrangement trend of the connection points connected through vias and to prevent the display substrate from producing mura defects. For example, the display substrate 10 includes a plurality of auxiliary line segments SA, and the connection line segment SC and the plurality of auxiliary line segments SA are arranged at intervals along the longitudinal direction Y.

For example, as shown in FIG. 1, the display region 1 further includes an upper edge 1c opposite to the lower edge 1a, the first power voltage lead 4 further includes an upper lead 43 extending along the upper edge 1c, and the upper lead 43 is electrically connected with the left lead 42; the upper end of the edge longitudinal voltage line YLP is connected with the upper lead 43, and the lower end of the edge longitudinal voltage line YLP opposite to the upper end thereof is directly connected with the lower lead 41.

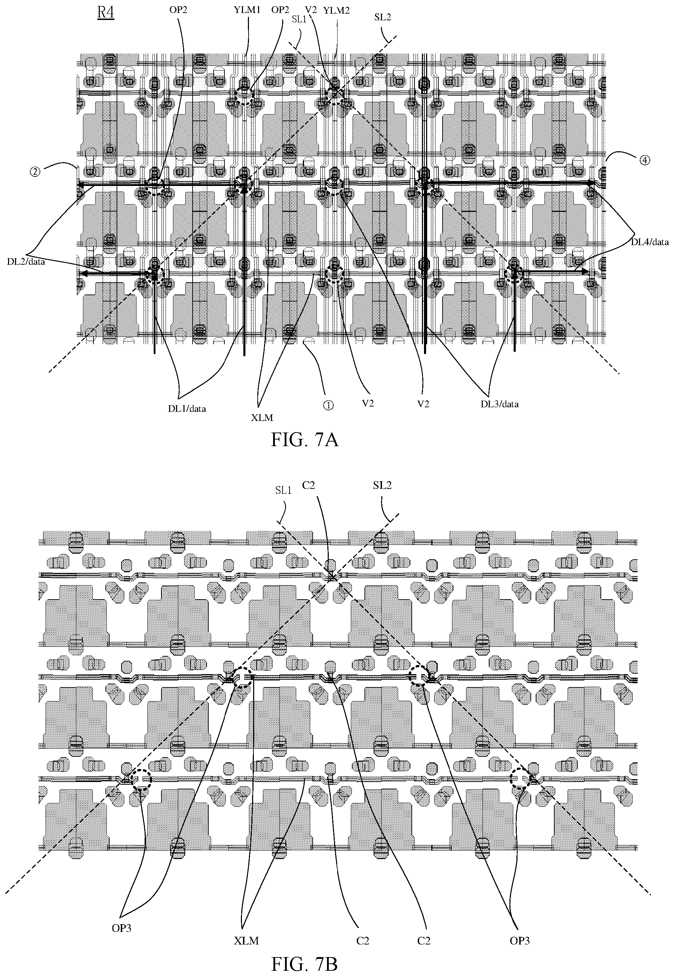

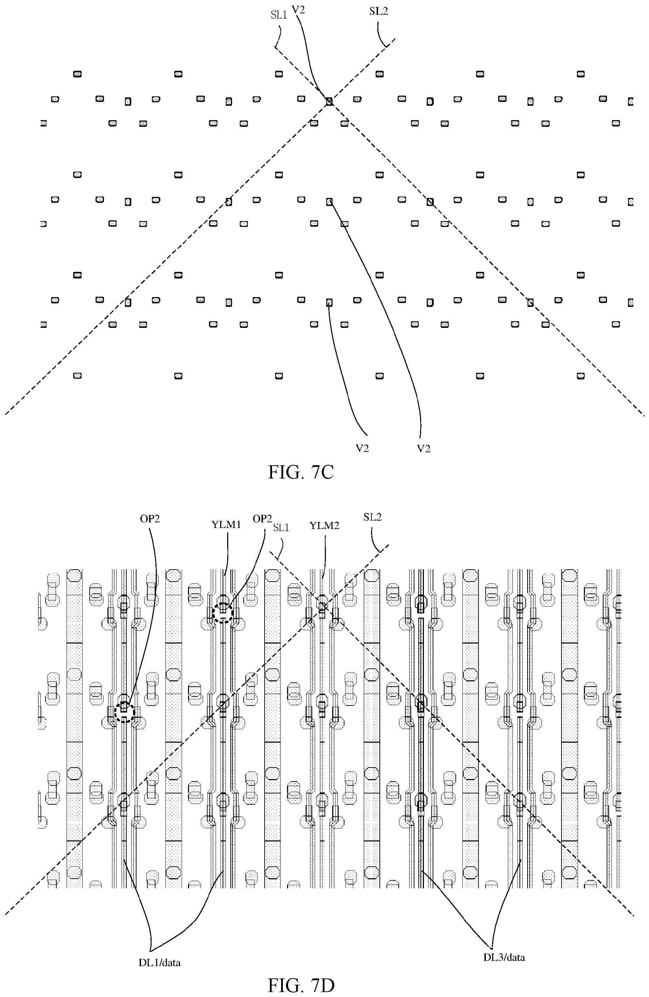

FIG. 7A is a partial enlarged view of the region R4 in FIG. 3, and FIGS. 7B-7D are schematic diagrams of part of layers in the region R4 in FIG. 3. For example, as shown in FIG. 1, the longitudinal voltage line YL includes a middle longitudinal voltage line YLM located in the first middle display region 11M, and the middle longitudinal voltage line YLM includes a first longitudinal voltage line YLM1 and a second longitudinal voltage line YML2. The first longitudinal voltage line YLM1 passes through the upper display region 13 and at least part of the second region (2) in sequence along the longitudinal direction Y. With reference to FIGS. 1 and 7A-7D, the upper end of the first longitudinal voltage line YLM1 is electrically connected with the upper lead 43, and the lower end of the first longitudinal voltage line YLM1 opposite to the upper end thereof is disconnected from the first connection line DL1 in the first sub-region A through a second opening OP2. The part shown in FIGS. 7A and 7D shows two second openings OP2 located in the region ②. The second longitudinal voltage line YML2 passes through the upper display region 13 and the first region ① in sequence along the longitudinal direction Y; the transverse voltage line XL includes a middle transverse voltage line XLM located in the first region ①, and the middle transverse voltage line XLM is disconnected from the second connection line DL2 in the second region ② through a third opening OP3. As shown in FIGS. 1-2, the right end of the middle transverse voltage line XLM opposite to the left end thereof in the first region ① is disconnected from the fourth connection line DL4 in the fourth region ④ through a fourth opening OP4. Therefore, both ends of each of the plurality of middle transverse voltage lines XLM in the transverse direction X are disconnected from a corresponding second connection line D2 and a corresponding fourth connection line DL4, respectively.

As shown in the figures, the second longitudinal voltage line YNΠ,2 intersects with the middle transverse voltage line XLM at a second intersection point P2, and the second longitudinal voltage line YMI,2 is electrically connected with the middle transverse voltage line XLM through a second via V2 at the second intersection point P2.

For example, the second longitudinal voltage line YMI,2 is electrically connected with the plurality of middle transverse voltage lines XLM arranged in the longitudinal direction through a plurality of second vias V2 arranged in the longitudinal direction Y, respectively. The part shown in FIGS. 7A-7D has three second vias V2, but it does not mean that the display substrate only has three second vias V2. For example, each of the plurality of middle transverse voltage lines XLM is electrically connected with the second longitudinal voltage line YNΠ,2 through the second via V2, so as to transmit the first power voltage VSS to each pixel in the first region ①. For example, as shown in FIG. 7B, the second longitudinal voltage line YNΠ,2 and the middle transverse voltage line XLM are connected through a second connection structure C2 passing through the second via V2.

For example, as shown in FIG. 1, the plurality of first transverse voltage lines XLU located in the upper display region 13 intersect with the second longitudinal voltage lines YNΠ,2 at a plurality of third intersection points P3, and at the position of each of at least part of the plurality of third intersection points P3, one first transverse voltage line XLU is electrically connected with one second longitudinal voltage line YNΠ,2 through a third via V3. Therefore, the middle transverse voltage line XLM is electrically connected with the second longitudinal voltage line YLM2 through the second via V2, while the second longitudinal voltage line YLM2 is electrically connected with the first transverse voltage line XLU through the third via V3, and the first transverse voltage line XLU is electrically connected with the first power voltage lead 4 (left lead 42), so that the first power voltage VSS is provided to the second longitudinal voltage line YMI,2 through the first transverse voltage line XLU, and the first power voltage VSS is provided to the middle transverse voltage line XLM through the second longitudinal voltage line YML2; thus, the first power voltage VSS is provided to the pixels in the first region ①, instead of providing the first power voltage VSS to the pixels in the first region ① by directly connecting the first power voltage line located in the first region ① with the first power voltage lead from the pad 3 and located in the frame region surrounding the lower edge 1b. As can be seen from FIGS. 1, 6A and 6D, the lower lead 41 is directly connected only with the edge longitudinal voltage line YLP located in the first edge display region 11P, and is not connected with the middle longitudinal voltage lines YLM located in the first middle display region 11M and the second middle display region 12M.

For example, both the second via V2 and the third via V3 penetrate through the first insulation layer.

For example, the first power voltage lead 4 is arranged in the same layer as the longitudinal voltage line YLP; for example, the first power voltage lead 4 and the longitudinal voltage line YLP are made of the same material, and are formed as a continuous integral structure, which can be constituted by a same patterning process, thus simplifying the structure and manufacturing process of the display substrate.

For example, as shown in FIG. 1, the display region 1 further includes a right edge 1d opposite to the left edge 1b, the first power lead further includes a right lead 44 extending along the right edge 1d, and the right lead 44 is electrically connected with the upper lead 43; each of the plurality of first transverse voltage lines XLU runs through the upper display region 13 along the transverse direction X, and the right end of each of the plurality of first transverse voltage lines XLU opposite to the left end thereof is electrically connected with the right lead 44, so that the first power voltage VSS is transmitted from the left and right ends of the first transverse voltage line XLU to the display region 1 at the same time, the signal transmission speed is improved, and it is helpful to improve the display quality of the display substrate.

For example, the plurality of middle longitudinal voltage lines YLM intersect with the plurality of first transverse voltage lines XLU in the upper display region 13 at a plurality of fourth intersection points P4 in the upper display region 13, so as to be connected in a mesh shape, which is helpful to reduce. At the position of each of part of the plurality of fourth intersection points P4, one middle longitudinal voltage line YLM is electrically connected with one first transverse voltage line XLU through a fourth via V4, so that the plurality of first transverse voltage lines XLU extending in the transverse direction X in the upper display region 13 and the middle longitudinal voltage lines YLM extending in the longitudinal direction Y are connected in a mesh shape, so as to reduce the resistance of this part of first power voltage line vss located in the upper display region 13 and reduce the voltage drop on the first power voltage line vss.

The planar pattern constituted by the positions of the plurality of fourth vias V4 is a zigzag line (dashed line) as a whole, so as to be consistent with the shape of the W-shaped zigzag line formed of the boundary SL1 (dashed line) between the second region ② and the third region ③, the boundary (i.e., fifth line segment) S5 (dashed line) between the second region ② and the fourth region ④ of the first region ①, the boundary (i.e., sixth line segment) S6 (dashed line) between the first region ① and the fourth region ④, and the boundary SL3 (dashed line) between the fourth region ④ and the fifth region ⑤. It is helpful to maintain the uniformity of the arrangement trend of the connection points connected through vias in the lower display region 14 and the connection points connected through vias in the upper display region 13, thus preventing the display substrate from producing mura display defects.

One middle longitudinal voltage line YLM is electrically connected with one first transverse voltage line XLU through a fourth via V4, which is the same as the structure of the region R1 shown in FIGS. 3A-3D. FIGS. 3A-3D can be referred to, which is not repeated here.

For example, as shown in FIG. 1, the zigzag line includes a plurality of sub-zigzag lines extending from the left edge 1b to the right edge 1d, and each of the plurality of sub-zigzag lines includes a plurality of zigzag line segments connected end to end; the plurality of zigzag line segments include a first line segment S1 (dashed line) extending in a first direction and a second line segment S2 (dashed line) extending in a second direction, the first direction intersects with the second direction, and both the first direction and the second direction intersect with the transverse direction X and the longitudinal direction Y. A first end of the first line segment S1 coincides with a first end of the second line segment S2, and for example, the first end of the first line segment S1 intersects with the first end of the second line segment S2 at an upper vertex TP; the plurality of vertices of the plurality of sub-zigzag lines are located on the second longitudinal voltage line YML2, and the fourth vias V4 at the positions of the vertices are all second vias V2.

For example, as shown in FIG. 1, each of the plurality of sub-zigzag lines is W-shaped. One W-shaped dashed line in FIG. 1 is a sub-zigzag line.

For example, the W-shaped sub-zigzag line includes a first line segment S1 (dashed line), a second line segment S2 (dashed line), a third line segment S3 (dashed line) and a fourth line segment S4 (dashed line); the first line segment S1 and the second line segment S2 are located between the third line segment S3 and the fourth line segment S4, the third line segment S3 is connected with the first line segment S1, and the fourth line segment S4 is connected with the second line segment S2; the first line segment S1 is substantially parallel to the fourth line segment S4, and the second line segment S2 is substantially parallel to the third line segment S3.

For example, the longitudinal direction is perpendicular to the transverse direction, the included angle between the first line segment S1 and the transverse direction is 45 degrees, and the included angle between the second line segment S2 and the transverse direction is 45 degrees, so as to ensure that the middle longitudinal voltage line YLM is connected with the first transverse voltage line XLU at more intersection points through the fourth vias V4 while maintaining the W-shaped wiring as much as possible.

For example, in the longitudinal direction Y, the auxiliary line segment SA is located between the third line segment S3 of two adjacent sub-zigzag lines.

For example, the connection line segment SC, the auxiliary line segment SA, and the third line segment S3 are substantially parallel to each other, so as to maintain the uniformity of the arrangement trend of the connection points connected through vias at various positions in the first edge display region 11P, and to prevent the display substrate from producing mura display defects.

For example, as shown in FIG. 2, the second longitudinal voltage line YNΠ,2 divides the first region ① into the first sub-region A and the second sub-region B, and the structure of the first sub-region A and the structure of the second sub-region B are substantially axially symmetrical with respect to the second longitudinal voltage line YML2; the lower display region 14 includes a fourth region 40, and the structure of the fourth region ④ and the structure of the second region ② are substantially axially symmetrical with respect to the second longitudinal voltage line YML2; the data line Data passing through the first region ① and the fourth region ④ includes a third connection line DL3 extending in the longitudinal direction Y in the second sub-region B, a fourth connection line DL4 extending in the transverse direction X in the fourth region 40, and a sixth connection line DL6 extending in the longitudinal direction Y in the upper display region 13, and the sixth connection line DL6 and the first connection line DL1 are arranged in a same layer; the third connection line DL3 and the longitudinal voltage line YL are arranged in a same layer, the fourth connection line DL4 and the transverse voltage line XL are arranged in a same layer, and the third connection line DL3 and the fourth connection line DL4 of the same data line Data are electrically connected through a second connection via VC2; the sixth connection line DL6 and the fourth connection line DL4 are electrically connected through a fourth connection via VC4, so as to form a conduction path of the data signal on the data line Data.

For example, the display substrate 10 includes a plurality of first connection lines DL1, a plurality of second connection lines DL2, a plurality of third connection lines DL3 and a plurality of fourth connection lines DL4; the plurality of first connection lines DL1 and the plurality of second connection lines DL2 are electrically connected through a plurality of first connection vias VC1 respectively, and the plurality of third connection lines DL3 and the plurality of fourth connection lines DL4 are electrically connected through a plurality of second connection vias VC2 respectively; the planar pattern constituted by the plurality of first connection vias VC1 is a fifth line segment S5 as a whole, and the fifth line segment S5 is the boundary between the first region ① and the second region (2); the planar pattern constituted by the plurality of second connection vias VC2 is a sixth line segment S6 as a whole, and the sixth line segment S6 is the boundary between the first region ① and the fourth region ④; the lower display region 14 further includes a fifth region ⑤, the structure of the fifth region and the structure of the third region ③ are substantially axially symmetrical with respect to the second longitudinal voltage line YML2, and the planar pattern constituted by a plurality of fifth vias V5 symmetrical with the plurality of first vias V1 in the fifth region ⑤ is a seventh line segment S7 as a whole. As shown in FIG. 1, the planar pattern constituted by sequentially connecting the line segment SC (dashed line), the fifth line segment S5 (dashed line), the sixth line segment S6 (dashed line) and the seventh line segment S7 (dashed line) is the same as the planar pattern of each sub-zigzag line (e.g., a W-shaped sub-zigzag line) among the plurality of sub-zigzag lines, so as to maintain the uniformity of the arrangement trend of the connection points connected through vias in the lower display region 14 and the connection points connected through vias in the upper display region 13, thus preventing the display substrate from producing mura display defects.

For example, as shown in FIG. 1, the boundary between the second region ② and the third region ③ is also the first edge SL1 of the second region ②, and the included angle between the first line segment S1 and the transverse direction X is less than the included angle between the first edge SL1 and the transverse direction X.

For example, as shown in FIGS. 1 and 2, the planar shape of the first region ① is a first triangle, and the planar shape of the second region ② is a second triangle. A second edge of the first triangle close to the left edge 1b in the transverse direction X (i.e. the second connection line SL2) at least partially overlaps with a first edge of the second triangle away from the left edge 1b of the display region 1 in the transverse direction X; two lower vertices DP1 and DP2 of the first triangle are located on the lower edge 1a of the display region 1, and the left vertex of the two lower vertices of the first triangle close to the left edge 1b is the left endpoint PO of the first sub-region A; the first triangle is an isosceles triangle, and the second longitudinal voltage line YMI,2 is substantially a perpendicular bisector of the bottom edge of the isosceles triangle. This arrangement manner can make the arrangement of data lines and first power voltage lines in the entire display region 1 uniform, and prevent the display substrate from producing mura defects.

FIG. 8A is a partial enlarged view of the region R5 in FIG. 3, and FIGS. 8B-8C are schematic diagrams of part of layers in the region R5 in FIG. 3. For example, referring to FIGS. 1 and 8A-8C, the frame region 2 includes a left frame region 2a extending along the left edge 1b, a plurality of auxiliary connection lines ACL extending in the transverse direction X are arranged in the left frame region 2a, and the plurality of auxiliary connection lines ACL are arranged in the same layer as the edge longitudinal voltage line YLP. The display region 1 includes a pixel array, and the pixel array includes a plurality of pixel rows extending in the transverse direction X and a plurality of pixel columns extending in the longitudinal direction Y. For example, the plurality of auxiliary connection lines ACL are in one-to-one correspondence with the plurality of first transverse voltage lines XLU, and are in one-to-one correspondence with a plurality of pixel rows in the upper display region 13. The plurality of pixel columns include an edge pixel column PXC0 closest to the left edge 1b, and the plurality of edge longitudinal voltage lines YLP include an outer edge longitudinal voltage line YLP-1 passing through the edge pixel column PXC0; the left end of each of the plurality of auxiliary connection lines ACL in the transverse direction X is electrically connected, for example, directly connected, with the left lead 42; the right end of each of the plurality of auxiliary connection lines ACL opposite to the left end thereof in the transverse direction X is electrically connected with the outer edge longitudinal voltage line YLP, and is electrically connected with the left end of a corresponding first transverse voltage line XLU through a second edge via VP2.

For example, the auxiliary connection line ACL and the left lead 42 are arranged in a same layer; for example, the auxiliary connection line ACL and the left lead 42 are made of the same material, and are a continuous integral structure. Of course, the materials of the auxiliary connection line ACL and the left lead 42 may be different.

Here, taking the case in the left frame region 2a as an example, a plurality of auxiliary connection lines ACL are also provided in the right frame region opposite to the left frame region in the transverse direction X. The connection manner between the auxiliary connection line ACL in the right frame region and the right end of the first transverse voltage line XLU is the same as the connection manner between the auxiliary connection line ACL in the left frame region 2a and the left end of the first transverse voltage line XLU, and details will not be repeated here.

For example, referring to FIG. 1, the right display region 12 includes a second edge display region 12P extending along the right edge 1d and a second middle display region 12M located at a side of the second edge display region 12P close to the left display region 11; the second edge display region 12P and the first edge display region 11P are symmetrical with respect to an axis of symmetry extending in the longitudinal direction Y, and the second middle display region 12M and the first middle display region 11M are axially symmetrical with respect to the second longitudinal voltage line YML2. The first middle display region 11M and the second middle display region 12M constitute a middle display region, the second sub-region B is located in the second middle display region 12M, and the first region ① is located in the middle display region.

For example, the first power voltage lead 4 further includes another lower lead 45 extending along a portion of the lower edge 1a corresponding to the second edge display region 12P. For example, the edge voltage line providing the first power voltage VSS to the second edge display region 12P is in contact with the another lower lead 45 for electrical connection, and for example, they are directly connected, that is, the edge voltage line providing the first power voltage VSS to the second edge display region 12P and another lower lead 451 are in contact with each other, and there is no any other structure between the edge voltage line providing the first power voltage VSS to the second edge display region 12P and the another lower lead 45 as a medium for connecting the two. For example, the edge voltage line providing the first power voltage VSS to the second edge display region 12P and the another lower lead 45 are arranged in a same layer, and form a continuous integral structure.

Of course, in other embodiments, the edge voltage line providing the first power voltage VSS to the second edge display region 12P and the another lower lead 45 may be arranged in different layers, and they are in contact with each other through a via.

For example, the display substrate 10 further includes a second power voltage line vdd (not shown in FIG. 1), and the second power voltage line vdd is configured to provide a second power voltage different from the first power voltage VSS to the sub-pixels; for example, the polarity of the first power voltage VSS is opposite to the polarity of the second power voltage VDD. For example, the first power voltage VSS is at a low level, and the second power voltage VDD is at a high level. Of course, the first power voltage VSS may be at a high level, and the second power voltage VDD may be at a low level.

For example, the longitudinal voltage line YL is arranged in the same layer as the data line *data* in the upper display region 13, and the transverse voltage line XL is arranged in the same layer as the second power voltage line.

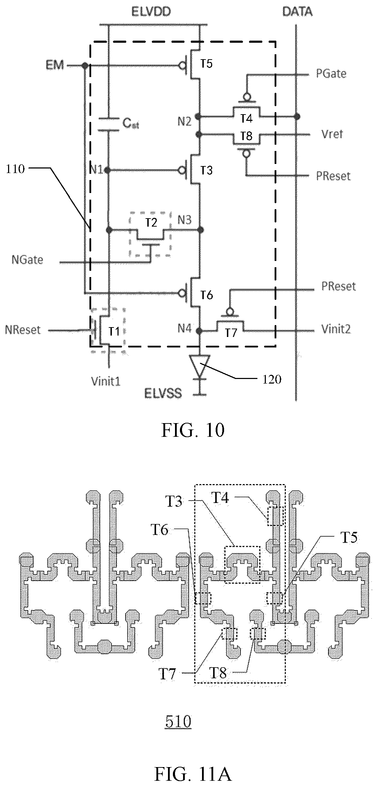

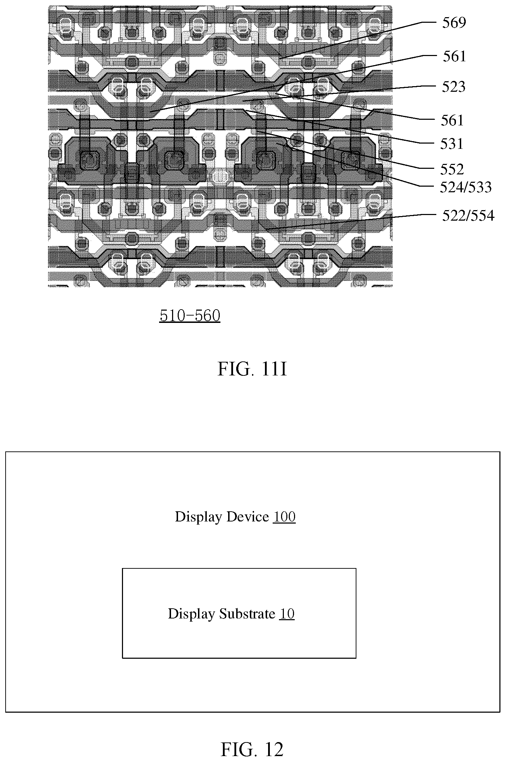

FIG. 10 is an equivalent circuit diagram of a pixel circuit according to an embodiment of the present disclosure, FIGS. 11A-11H are schematic diagrams including different layers in the pixel circuit, and FIG. 11I is a schematic diagram of a stack of the layers shown in FIGS. 11A-11H. The dashed frame in FIG. 11A represents the region of one sub-pixel.

In some examples, as shown in FIG. 10, the display substrate further includes a plurality of sub-pixels, at least part of the sub-pixels include a light-emitting element 120 and a pixel circuit 110 electrically connected with the light-emitting element 120.

For example, as shown in FIGS. 10-11I, the pixel circuit includes a plurality of transistors and at least one capacitor. For example, the pixel circuit includes a second reset transistor T1, a threshold compensation transistor T2, a driving transistor T3, a data writing transistor T4, a second light-emitting control transistor T5, a first light-emitting control transistor T6, a first reset control transistor T7, a third reset transistor T8 and a storage capacitor C.

For example, as shown in FIGS. 10-11I, the display substrate further includes reset power signal lines 561, 551, and 554, scan signal lines 552, 531, and 523, a second power voltage line vdd, reset control signal lines 522, 532, and 553, a light-emitting control signal line 521, and a data line 582.

For example, as shown in FIGS. 10-11I, the first electrode of the threshold compensation transistor T2 is electrically connected with the first electrode of the driving transistor T3, the second electrode of the threshold compensation transistor T2 is electrically connected with the gate electrode of the driving transistor T3, and the gate electrode of the threshold compensation transistor T2 is electrically connected with the scan signal lines 531 and 552 to receive a compensation control signal; the first electrode of the first reset control transistor T7 is electrically connected with the reset power signal line 561 to receive a reset signal Vinit2, the second electrode of the first reset control transistor T7 is electrically connected with the first electrode of the light-emitting element (i.e. the node N4), and the gate electrode of the first reset control transistor T7 is electrically connected with the reset control signal line 522 to receive a reset control signal Reset(N+1); the first electrode of the third reset transistor T8 is electrically connected with the reset power signal line 551 to receive a reset signal Vref, the second electrode of the third reset transistor T8 is electrically connected with the second electrode of the driving transistor T3, and the gate electrode of the third reset transistor T8 is electrically connected with the reset control signal line 522; the first electrode of the data writing transistor T4 is electrically connected with the second electrode of the driving transistor T3, the second electrode of the data writing transistor T4 is electrically connected with the data line 200 (data line *data*) to receive a data signal DATA, and the gate electrode of the data writing transistor T4 is electrically connected with the scan signal line 523 to receive a scan signal Gate; the first electrode of the storage capacitor C is electrically connected with the second power signal line vdd, and the second electrode of the storage capacitor C is electrically connected with the gate electrode of the driving transistor T3; the first electrode of the second reset transistor T1 is electrically connected with the reset power signal line 554 to receive a reset signal Vinit1, the second electrode of the second reset transistor T1 is electrically connected with the gate electrode of the driving transistor T3, and the gate electrode of the second reset transistor t1 is electrically connected with the reset control signal lines 553 and 532 to receive a reset control signal Reset(N); the gate electrode of the first light-emitting control transistor T6 is electrically connected with the light-emitting control signal line 521 to receive a light-emitting control signal EM, the first electrode of the first light-emitting control transistor T6 is electrically connected with the first electrode of the driving transistor T3, and the second electrode of the first light-emitting control transistor T6 is electrically connected with the first electrode of the light-emitting element 120; the first electrode of the second light-emitting control transistor T5 is electrically connected with the second power signal line vdd to receive a first power signal VDD, the second electrode of the second light-emitting control transistor T5 is electrically connected with the second electrode of the driving transistor T3, the gate electrode of the second light-emitting control transistor T5 is electrically connected with the light-emitting control signal line 521 to receive the light-emitting control signal EM, and the second electrode of the light-emitting element 120 is electrically connected with a voltage terminal VSS (the subsequent third signal line 600). The above-mentioned power signal line refers to a signal line that outputs the voltage signal VDD, and can be connected with a voltage source to output a constant voltage signal, such as a positive voltage signal.

It should be noted that, in the embodiment of the present disclosure, in addition to the 8T1C (i.e., eight transistors and one capacitor) structure shown in FIG. 10, the various pixel circuits may also be a structure including other numbers of transistors, such as a 7T1C structure, a 7T2C structure, a 6T1C structure, a 6T2C structure or a 9T2C structure, which is not limited in the embodiment of the present disclosure.

FIG. 11A shows an active semiconductor pattern 510. For example, as shown in FIG. 11A, the active semiconductor pattern 510 can be used to manufacture the active layers of the driving transistor T3, the data writing transistor T4, the second light-emitting control transistor T5, the first light-emitting control transistor T6, the first reset control transistor T7 and the third reset transistor T8 described above, so as to form the channel regions of the above-mentioned transistors. The active semiconductor pattern 510 includes active region patterns (channel regions) and doped region patterns (source/drain regions) of the above-mentioned transistors of each sub-pixel, and the active region patterns and the doped region patterns of the above-mentioned transistors in the same pixel circuit are integrally arranged.

For example, the active semiconductor pattern 510 may include an integrally formed low-temperature poly-silicon layer, and the source region and the drain region can be conductive through doping or the like, so as to achieve electrical connection between the various structures. For example, the source region and the drain region can be regions doped with P-type impurities.

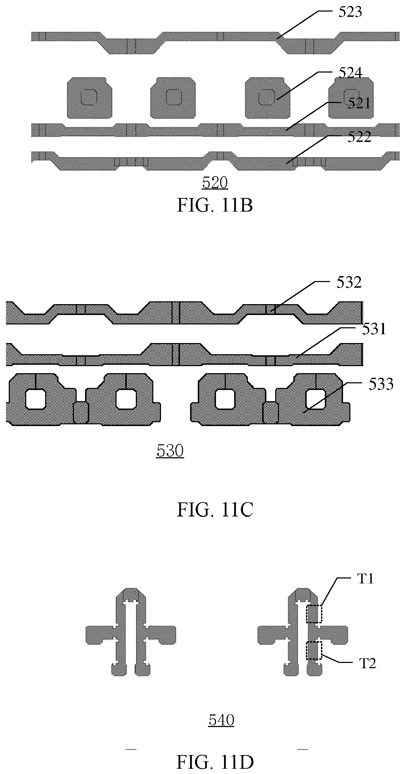

FIG. 11B shows a first conductive layer pattern 520 located at a side of the active semiconductor pattern 510 away from the base substrate. For example, as shown in FIG. 11B, the first conductive layer pattern 520 includes a reset control signal line 522, a scan signal line 523, a first electrode 524 of the storage capacitor, and a light-emitting control signal line 521. For example, the first conductive layer pattern 520 may include gate electrodes of the driving transistor T3, the data writing transistor T4, the second light-emitting control transistor T5, the first light-emitting control transistor T6, the first reset control transistor T7 and the third reset transistor T8.

It should be noted that the various dashed rectangular frame in FIG. 11A show the respective portion of the active semiconductor pattern 510 overlapped with the first conductive layer pattern 520, that is, the channel region. As the channel region of each transistor, the parts of the active semiconductor layer on two sides of each channel region are conductive through processes, such as ion doping or the like, so as to serve as the first electrode and the second electrode of each transistor. The source electrode and the drain electrode of the transistor may be symmetrical in structure, so there may be no difference in physical structure between the source electrode and the drain electrode. In the embodiment of the present disclosure, in order to distinguish transistors, except for the gate electrode as the control electrode, one of the remaining electrodes is directly described as the first electrode and the other as the second electrode. Therefore, the first electrode and the second electrode of all or part of the transistors in the embodiments of the present disclosure can be interchanged as needed.

For example, as shown in FIGS. 11B and 11I, the gate electrode of the data writing transistor T4 may be a portion of the scan signal line 523 overlapped with the active semiconductor pattern 510; the gate electrode of the first light-emitting control transistor T6 may be a first portion of the light-emitting control signal line 521 overlapped with the active semiconductor pattern 510, and the gate electrode of the second light-emitting control transistor T5 may be a second portion of the light-emitting control signal line 521 overlapped with the active semiconductor pattern 510. The gate electrode of the third reset transistor T8 is a first portion of the reset control signal line 522 overlapped with the active semiconductor pattern 510, and the gate electrode of the first reset control transistor T7 is a second portion of the reset control signal line 522 overlapped with the active semiconductor pattern 510.

FIG. 11C shows a second conductive layer pattern 530 located at a side of the first conductive layer pattern 520 away from the base substrate. For example, as shown in FIG. 11C, the second conductive layer pattern 530 includes a scan signal line 531, a second electrode 533 of the storage capacitor C, and a reset control signal line 532.

FIG. 11D shows an active layer pattern 540 located at a side of the second conductive layer pattern 530 away from the base substrate. For example, as shown in FIG. 11D, the active layer pattern 540 includes channel regions of the second reset transistor T1 and the threshold compensation transistor T2. For example, in the case where the active layers of the second reset transistor T1 and the threshold compensation transistor T2 are made of an oxide semiconductor, the transistors made of the oxide semiconductor have the features of good hysteresis characteristics and low leakage current, as well as low mobility, so the transistors made of the oxide semiconductor can be used instead of the transistors made of a low-temperature poly-silicon material to form a low-temperature polycrystalline oxide (LTPO) pixel circuit, thus achieving low leakage and improving the stability of the gate voltage of the transistors.

For example, as shown in FIGS. 11C, 11D and 11I, the gate electrode of the second reset transistor T1 may be a portion of the reset control signal line 532 overlapped with the active layer pattern 540, and the gate electrode of the threshold compensation transistor T2 may be a portion of the scan signal line 531 overlapped with the active layer pattern 540.

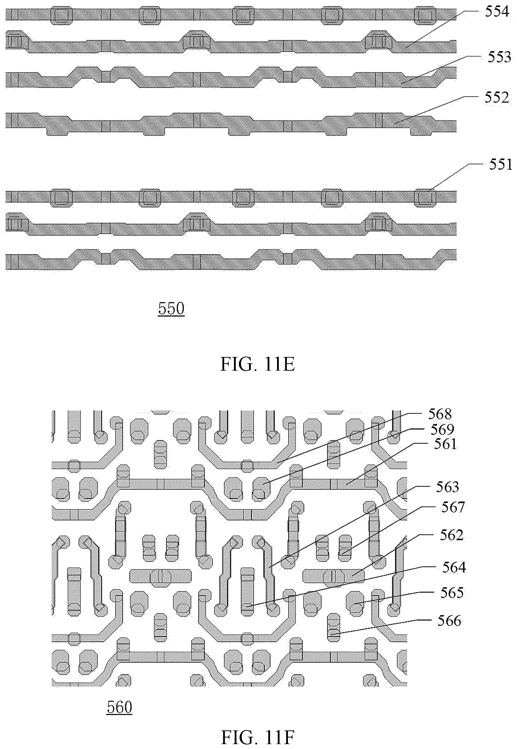

FIG. 11E shows a third conductive layer 550 located at a side of the active layer pattern 540 away from the base substrate. For example, as shown in FIG. 11E, the third conductive layer 550 includes a reset power signal line 554, a reset control signal line 553, a scan signal line 552, and a reset power signal line 551.

For example, as shown in FIGS. 11C-11F and 11I, the reset control signal line 553 overlaps with the channel region of the second reset transistor T1, the second reset transistor T1 includes double gates located at two sides of the active layer, and the second reset transistor T1 is a dual-gate transistor; the scan signal line 552 overlaps with the channel region of the threshold compensation transistor T2, the threshold compensation transistor T2 includes double gates located at two sides of the active layer, and the threshold compensation transistor T2 is a dual-gate transistor.

For example, the second reset transistor T1 and the threshold compensation transistor T2 may be N-type transistors. The driving transistor T3, the data writing transistor T4, the second light-emitting control transistor T5, the first light-emitting control transistor T6, the first reset control transistor T7 and the third reset transistor T8 may be P-type transistors.

FIG. 11F shows a fourth conductive layer 560 located at a side of the third conductive layer 550 away from the base substrate. For example, as shown in FIG. 11F, the fourth conductive layer 560 includes a reset power signal line 561, a connection portion 568, a connection portion 569, a connection portion 563, a connection portion 567, a connection portion 562, a connection portion 564, a connection portion 565 and a connection portion 566.

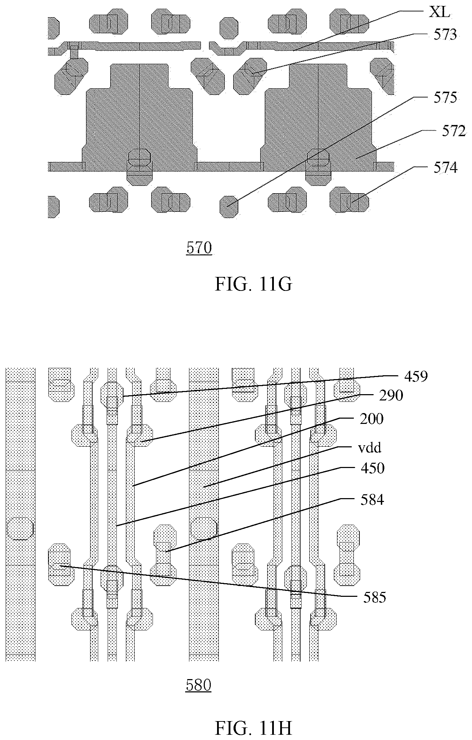

For example, as shown in FIGS. 10-11I, two ends of the connection portion 568 are connected to the reset power signal line 551, and the middle of the connection portion 568 is connected to the first electrode of the third reset transistor T8; the connection portion 569 connects the data line Data with the second electrode of the data writing transistor T4; the connection portion 563 is used to electrically connect the first electrode of the data writing transistor T4 and the second electrode of the third reset transistor T8, so as to lead the reset signal Vref to the node N2; the connection portion 567 is configured to electrically connect the first electrode of the driving transistor T3 with the first electrode of the threshold compensation transistor T2; the middle of the connection portion 562 is connected to the second power voltage line vdd (as shown in FIG. 11H, that is, the second power voltage line vdd), and two ends of the connection portion 562 are connected to the second electrodes 533 of the respective capacitors; one end of the connection portion 564 is connected to the second electrode 533 of the capacitor C, and the other end of the connection portion 564 is connected to the first electrode of the second light-emitting control transistor T5; the connection portion 565 is used to electrically connect the first electrode of the light-emitting element with the second electrode of the first light-emitting control transistor T6; the connection portion 566 is used to electrically connect the reset power signal line 554 with the first electrode of the second reset transistor T1.

FIG. 11G shows a fifth conductive layer 570 located at a side of the fourth conductive layer 560 away from the base substrate. For example, as shown in FIG. 11G, the fifth conductive layer 570 includes a connection portion 573, a connection portion 575, a second power signal line 572 (transmitting the second power voltage VDD), a connection portion 574, and a transverse voltage line XL (e.g., a middle transverse voltage line XLM, etc.). For example, the fifth conductive layer 570 further includes a fourth connection line.

For example, as shown in FIGS. 10-11G, the connection portion 573 is used to be electrically connected with the data line *data.* For example, the data line *data* is electrically connected with some connection lines that extend in the transverse direction X in the display region 1 and are arranged in a different layer from the data line *data* through the connection portion 573, so as to transmit data signals to the connection lines. The connection portion 575 is a reserved pad, and the first connection line can be electrically connected with the second connection line through the reserved pad, or the longitudinal voltage line can be electrically connected with the transverse voltage line through the reserved pad. For example, the connection portion 574 is electrically connected with the connection portion 565, so as to realize the electrical connection between the second electrode of the first light-emitting control transistor T6 and the first electrode of the light-emitting element. For example, the second power voltage line 572 is electrically connected with the second power voltage line vdd.

FIG. 11H shows a sixth conductive layer 580 located at a side of the fifth conductive layer 570 away from the base substrate. For example, as shown in FIG. 11H, the sixth conductive layer 580 includes a data line *data,* a second power signal line vdd, a fifth connection line 450, a connection portion 584 and a connection portion 585.

For example, the connection portion 584 and the connection portion 585 are electrically connected with the first electrodes of different light-emitting elements.

For example, as shown in FIGS. 11G and 11H, the data line *data* includes a transfer pad 290, and the data line *data* is connected with the connection portion 573 through the transfer pad 290, so as to be electrically connected with some connection lines that extend in the transverse direction X in the display region 1 and are arranged in a different layer from the data line *data,* thus transmitting data signals to the connection lines. For example, each longitudinal voltage line YL includes a transfer pad 459, and the longitudinal voltage line YL can be electrically connected with the connection portion 575 through a corresponding transfer pad 459, and the connection portion 575 is electrically connected with a corresponding transverse voltage line XL that needs to be electrically connected with the longitudinal voltage line YL, so that the longitudinal voltage line YL can be electrically connected with the transverse voltage line XL.

As shown in FIG. 12, at least one embodiment of the present disclosure further provides a display device 100, which includes any display substrate 10 provided by at least one embodiment of the present disclosure.

What have been described above are only specific implementations of the present disclosure, the protection scope of the present disclosure is not limited thereto, and the protection scope of the present disclosure should be based on the protection scope of the claims.

## Claims

1. A display substrate, comprising:
a display region, provided with sub-pixels and having a lower edge extending in a transverse direction and a left edge extending in a longitudinal direction, wherein the transverse direction intersects with the longitudinal direction, the display region comprises a left display region and a right display region that are arranged in the transverse direction, and the left display region comprises a first edge display region extending along the left edge and a first middle display region located at a side of the first edge display region close to the right display region;
a non-display region, comprising a frame region surrounding at least part of the display region;
a first power voltage lead, configured to provide a first power voltage, and located in the frame region, wherein the first power voltage lead comprises a lower lead extending along a portion of the lower edge corresponding to the first edge display region, and the first power voltage lead does not extend along a portion of the lower edge corresponding to the first middle display region;
a first power voltage line, comprising an edge voltage line located in the first edge display region and a middle voltage line located in the first middle display region, wherein the edge voltage line is in contact with the lower lead to be electrically connected with the lower lead so as to provide a first power voltage to sub-pixels located in the first edge display region, and the middle voltage line is spaced apart from the lower lead.

2. The display substrate according to claim 1, wherein the first power voltage line comprises a longitudinal voltage line extending in the longitudinal direction and a transverse voltage line extending in the transverse direction, and the longitudinal voltage line and the transverse voltage line are arranged in different layers;
the longitudinal voltage line comprises an edge longitudinal voltage line located in the first edge display region, the transverse voltage line comprises an edge transverse voltage line that is located in the first edge display region and intersected with the edge longitudinal voltage line, and the edge longitudinal voltage line and the edge transverse voltage line constitute the edge voltage line;
the first power voltage lead further comprises a left lead extending along the left edge of the display region, the edge longitudinal voltage line is directly connected with the lower lead, and the edge transverse voltage line is directly connected with the left lead.

3. The display substrate according to claim 2, further comprising a data line, wherein the sub-pixel comprises a driving transistor, a light-emitting element and a data transistor, the driving transistor is configured to control a magnitude of a driving current flowing through the light-emitting element, the light-emitting element is configured to receive the driving current and be driven by the driving current to emit light, the data transistor is configured to write a data signal to a gate electrode of the driving transistor in response to a first control signal, and the data line is configured to transmit the data signal to the sub-pixel;
the display region comprises a lower display region and an upper display region, the lower display region is close to the lower edge, and the upper display region is located at a side of the lower display region away from the lower edge in the longitudinal direction;
the lower display region comprises a first region and a second region, the first region comprises a first sub-region close to the left edge and a second sub-region away from the left edge in the transverse direction, and the data line passing through the first sub-region and the second region comprises a first connection line extending in the longitudinal direction in the first sub-region and a second connection line extending in the transverse direction in the second region; the first connection line and the longitudinal voltage line are arranged in a same layer, the second connection line and the transverse voltage line are arranged in a same layer, and the first connection line and the second connection line of one same data line are electrically connected through a first connection via; the first sub-region is located in the first middle display region, and the second region is at least partially located in the middle display region;
the first sub-region has a left endpoint closest to the left edge of the display region in the transverse direction, and a straight line extending in the longitudinal direction and passing through the left endpoint is a boundary between the first edge display region and the first middle display region.

4. The display substrate according to claim 3, wherein the boundary passes through the second region and divides the second region into a first sub-region close to the left edge of the display region and a second sub-region away from the left edge of the display region, the first sub-region is located in the first edge display region, and the second sub-region is located in the first middle display region;
the lower display region further comprises:
a third region, located in the first edge display region and at a side of the second region away from the first region in the transverse direction,
wherein the edge transverse voltage line comprises a lower edge transverse voltage line located in the third region, the edge longitudinal voltage line passes through the third region and intersects with the lower edge transverse voltage line at a first intersection point, a left end of the lower edge transverse voltage line is electrically connected with the left lead, and a right end of the lower edge transverse voltage line opposite to the left end thereof is disconnected from the second connection line in the second region through a first opening;
the longitudinal voltage line comprises a plurality of the edge longitudinal voltage lines and a plurality of the edge transverse voltage lines, the plurality of edge longitudinal voltage lines and the plurality of edge transverse voltage lines are interwoven into a mesh, and the mesh comprises a plurality of the first intersection points;
at a position of each of part of the plurality of first intersection points, one edge longitudinal voltage line is electrically connected with one lower edge transverse voltage line through a first via.

5. The display substrate according to claim 4, wherein the plurality of edge longitudinal voltage lines are electrically connected with the plurality of edge transverse voltage lines through a plurality of the first vias, a planar pattern constituted by positions of the plurality of first vias is a connection line segment as a whole located in the third region, and an extension direction of the connection line segment intersects with both the first direction and the second direction.

6. The display substrate according to claim 4 or 5, wherein the third region is a corner region defined by a second edge of the second region close to the left edge in the transverse direction, the left edge and the lower edge.

7. The display substrate according to claim 6, wherein the frame region comprises a frame corner region surrounding the corner region, and a mesh-shaped auxiliary first power voltage line is arranged in the frame corner region, and the mesh-shaped auxiliary first power voltage line comprises:
a plurality of vertical auxiliary voltage lines, extending in the longitudinal direction and arranged in a same layer as the longitudinal voltage line, wherein a first end of each of the plurality of vertical auxiliary voltage lines in the longitudinal direction is directly connected with the first power voltage lead, and a second end of each of the plurality of vertical auxiliary voltage lines opposite to the first end thereof in the longitudinal direction is electrically connected with one of the edge longitudinal voltage lines passing through the corner region; and
a plurality of horizontal auxiliary voltage lines, extending in the transverse direction and arranged in a same layer as the plurality of vertical auxiliary voltage lines, wherein a first end of each of the plurality of horizontal auxiliary voltage lines in the transverse direction is directly connected with the first power voltage lead, and a second end of each of the plurality of horizontal auxiliary voltage lines in the transverse direction opposite to the first end thereof is electrically connected with one of the edge longitudinal voltage lines.

8. The display substrate according to claim 7, wherein the display region comprises a pixel array, the pixel array comprises a plurality of pixel rows extending in the transverse direction and a plurality of pixel columns extending in the longitudinal direction; the plurality of pixel rows comprise a plurality of edge pixel rows close to the lower edge; the plurality of horizontal auxiliary voltage lines are in one-to-one correspondence with the plurality of edge pixel rows, each edge pixel row in the plurality of edge pixel rows comprises an edge sub-pixel closest to the left edge, and the plurality of edge longitudinal voltage lines comprise an outermost edge longitudinal voltage line passing through the edge sub-pixel of the each edge pixel row;
the second end of each of the plurality of horizontal auxiliary voltage lines is electrically connected with the outermost longitudinal voltage line passing through a corresponding edge pixel row, and is electrically connected with the edge transverse voltage line passing through the corresponding edge pixel row through a first edge via.

9. The display substrate according to claim 5, wherein the transverse voltage line further comprises:
a plurality of first transverse voltage lines, arranged in the longitudinal direction and located in the upper display region, wherein a left end of each of the plurality of first transverse voltage lines is electrically connected with the left lead, the plurality of edge transverse voltage lines further comprise an upper edge transverse voltage line located in the upper display region, and the upper edge transverse voltage line serves as a portion of one of the first transverse voltage lines;
the longitudinal voltage line further comprises:
a plurality of middle longitudinal voltage lines, arranged in the transverse direction, passing through part of the first middle display region and passing through the upper display region along the longitudinal direction, wherein the plurality of middle longitudinal voltage lines, the plurality of edge longitudinal voltage lines and the plurality of first transverse voltage lines are interwoven into a mesh;
the plurality of edge longitudinal voltage lines intersect with the plurality of first transverse voltage lines at a plurality of auxiliary intersection points in the first edge display region, at a position of each of part of the plurality of auxiliary intersection points, one edge longitudinal voltage line is electrically connected with one first transverse voltage line through an auxiliary via; the plurality of edge longitudinal voltage lines are electrically connected with the plurality of first transverse voltage lines through a plurality of auxiliary vias;
a planar pattern constituted by positions of the plurality of auxiliary vias is an auxiliary line segment as a whole located in the first edge display region, and one end of the auxiliary line segment away from the left edge is suspended.

10. The display substrate according to claim 9, wherein an extension direction of the auxiliary line segment is the same as the extension direction of the connection line segment;
the display substrate comprises a plurality of the auxiliary line segments, and the connection line segment and the plurality of auxiliary line segments are arranged at intervals in the longitudinal direction.

11. The display substrate according to claim 9 or 10, wherein the display region further comprises an upper edge opposite to the lower edge, the first power voltage lead further comprises an upper lead extending along the upper edge, and the upper lead is electrically connected with the left lead;
an upper end of the edge longitudinal voltage line is connected with the upper lead, and a lower end of the edge longitudinal voltage line opposite to the upper end thereof is directly connected with the lower lead;
the longitudinal voltage line comprises a middle longitudinal voltage line located in the first middle display region, and the middle longitudinal voltage line comprises:
a first longitudinal voltage line, passing through the upper display region and at least part of the second region in sequence along the longitudinal direction, wherein an upper end of the first longitudinal voltage line is electrically connected with the upper lead, and a lower end of the first longitudinal voltage line opposite to the upper end thereof is disconnected from the first connection line in the first sub-region through a second opening; and
a second longitudinal voltage line, passing through the upper display region and the first region in sequence along the longitudinal direction, wherein the transverse voltage line comprises a middle transverse voltage line located in the first region, the middle transverse voltage line is disconnected from the second connection line in the second region through a third opening, the second longitudinal voltage line intersects with the middle transverse voltage line at a second intersection point, and the second longitudinal voltage line is electrically connected with the middle transverse voltage line through a second via at the second intersection point.

12. The display substrate according to claim 11, wherein the plurality of first transverse voltage lines intersect with the plurality of second longitudinal voltage lines at a plurality of third intersection points, and at a position of each of at least part of the plurality of third intersection points, one first transverse voltage line is electrically connected with one second longitudinal voltage line through a third via.

13. The display substrate according to claim 11 or 12, wherein the display region further comprises a right edge opposite to the left edge, the first power lead further comprises a right lead extending along the right edge, and the right lead is electrically connected with the upper lead;
each of the plurality of first transverse voltage lines runs through the upper display region along the transverse direction, and a right end of each of the plurality of first transverse voltage lines opposite to the left end thereof is electrically connected with the right lead.

14. The display substrate according to claim 13, wherein the plurality of middle longitudinal voltage lines intersect with the plurality of first transverse voltage lines at a plurality of fourth intersection points in the upper display region, and at a position of each of part of the plurality of fourth intersection points, one middle longitudinal voltage line is electrically connected with one first transverse voltage line through a fourth via;
a planar pattern constituted by positions of the plurality of fourth vias is a zigzag line as a whole.

15. The display substrate according to claim 14, wherein the zigzag line comprises a plurality of sub-zigzag lines extending from the left edge to the right edge, and each of the plurality of sub-zigzag lines comprises a plurality of zigzag line segments connected end to end;
the plurality of zigzag line segments comprise a first line segment extending in a first direction and a second line segment extending in a second direction, the first direction intersects with the second direction, both the first direction and the second direction intersect with the transverse direction and the longitudinal direction, and a first end of the first line segment intersects with a first end of the second line segment at an upper vertex;
a plurality of vertices of the plurality of sub-zigzag lines are located on a second longitudinal voltage line, and the fourth vias at positions of the vertices are all the second vias.

16. The display substrate according to claim 15, wherein each of the plurality of sub-zigzag lines is W-shaped.

17. The display substrate according to claim 16, wherein the W-shaped sub-zigzag line comprises the first line segment, the second line segment, a third line segment and a fourth line segment, the first line segment and the second line segment are located between the third line segment and the fourth line segment, the third line segment is connected with the first line segment, and the fourth line segment is connected with the second line segment;
the first line segment is substantially parallel to the fourth line segment, and
the second line segment is substantially parallel to the third line segment.

18. The display substrate according to claim 17, wherein the longitudinal direction is perpendicular to the transverse direction, an included angle between the first line segment and the transverse direction is 45 degrees, and an included angle between the second line segment and the transverse direction is 45 degrees.

19. The display substrate according to claim 17 or 18, wherein in the longitudinal direction, the auxiliary line segment is located between the third line segments of two adjacent sub-zigzag lines.

20. The display substrate according to claim 19, wherein the connection line segment, the auxiliary line segment and the third line segment are substantially parallel to each other.

21. The display substrate according to any one of claims 15-20, wherein the second longitudinal voltage line divides the first region into the first sub-region and the second sub-region, and a structure of the first sub-region and a structure of the second sub-region are substantially axially symmetrical with respect to the second longitudinal voltage line;
the lower display region comprises a fourth region, and a structure of the fourth region and a structure of the second region are substantially axially symmetrical with respect to the second longitudinal voltage line; the data line passing through the first region and the fourth region comprises a third connection line extending in the longitudinal direction in the second sub-region and a fourth connection line extending in the transverse direction in the fourth region; the third connection line and the longitudinal voltage line are arranged in a same layer, the fourth connection line and the transverse voltage line are arranged in a same layer, and the third connection line and the fourth connection line of one same data line are electrically connected through a second connection via;
a right end of the middle transverse voltage line located in the first region opposite to a left end thereof is disconnected from the fourth connection line in the fourth region through a fourth opening.

22. The display substrate according to claim 21, wherein the display substrate comprises a plurality of the first connection lines, a plurality of the second connection lines, a plurality of the third connection lines and a plurality of the fourth connection lines; the plurality of first connection lines and the plurality of second connection lines are electrically connected through a plurality of the first connection vias respectively, and the plurality of third connection lines and the plurality of fourth connection lines are electrically connected through a plurality of the second connection vias respectively;
a planar pattern constituted by the plurality of first connection vias is a fifth line segment as a whole, and the fifth line segment is a boundary between the first region and the second region;
a planar pattern constituted by the plurality of second connection vias is a sixth line segment as a whole, and the sixth line segment is a boundary between the first region and the fourth region;
the lower display region further comprises a fifth region, a structure of the fifth region and a structure of the third region are substantially axially symmetrical with respect to the second longitudinal voltage line, and a planar pattern constituted by a plurality of fifth vias which is in the fifth region and symmetrical with the plurality of first vias is a seventh line segment as a whole;
a planar pattern constituted by sequentially connecting the connection line segment, the fifth line segment, the sixth line segment and the seventh line segment is same as a planar pattern of each sub-zigzag line in the plurality of sub-zigzag lines.

23. The display substrate according to claim 21 or 22, wherein a planar shape of the first region is a first triangle, a planar shape of the second region is a second triangle, a first edge of the first triangle close to the left edge in the transverse direction at least partially overlaps with a first edge of the second triangle away from the left edge of the display region in the transverse direction; two lower vertices of the first triangle are located on the lower edge of the display region, and a left vertex of the two lower vertices of the first triangle close to the left edge is the left endpoint of the first sub-region;
the first triangle is an isosceles triangle, and the second longitudinal voltage line is substantially a perpendicular bisector of a bottom edge of the isosceles triangle.

24. The display substrate according to any one of claims 9-23, wherein the frame region comprises a left frame region extending along the left edge, a plurality of auxiliary connection lines extending in the transverse direction are arranged in the left frame region, and the plurality of auxiliary connection lines are arranged in a same layer as the edge longitudinal voltage line;
the display region comprises a pixel array, the pixel array comprises a plurality of pixel rows extending in the transverse direction and a plurality of pixel columns extending in the longitudinal direction; the plurality of pixel columns comprise an edge pixel column closest to the left edge, and the plurality of edge longitudinal voltage lines comprise an outer edge longitudinal voltage line passing through the edge pixel column;
a left end of each of the plurality of auxiliary connection lines in the transverse direction is electrically connected with the left lead, and a right end of each of the plurality of auxiliary connection lines opposite to the left end thereof in the transverse direction is electrically connected with the outer edge longitudinal voltage line, and is electrically connected with a left end of a corresponding first transverse voltage line through a second edge via.

25. The display substrate according to any one of claims 13-23, wherein the right display region comprises a second edge display region extending along the right edge and a second middle display region located at a side of the second edge display region close to the left display region;
the second edge display region and the first edge display region are symmetrical with respect to an axis of symmetry extending in the longitudinal direction, and the second middle display region and the first middle display region are axially symmetrical with respect to the second longitudinal voltage line.

26. The display substrate according to any one of claims 2-23, wherein the display substrate further comprises:
a second power voltage line, configured to provide a second power voltage different from the first power voltage to the sub-pixels;
the longitudinal voltage line is arranged in a same layer as the data line in the upper display region, and the transverse voltage line is arranged in a same layer as the second power voltage line.

27. A display device, comprising the display substrate according to any one of claims 1-26.
